(19) Europäisches Patentamt
European Patent Office
Office européen des brevets

(11) EP 4 387 413 A1

(12) EUROPEAN PATENT APPLICATION

(43) Date of publication:
**19.06.2024 Bulletin 2024/25**

(21) Application number: **22213855.4**

(22) Date of filing: **15.12.2022**

(51) International Patent Classification (IPC):
***H10K 50/16*** *(2023.01)* ***H10K 85/60*** *(2023.01)*
***H10K 50/19*** *(2023.01)*

(52) Cooperative Patent Classification (CPC):
**H10K 50/16; H10K 50/19; H10K 85/615; H10K 85/654**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Novaled GmbH**
**01099 Dresden (DE)**

(72) Inventors:
- **SCHOLZ, Johannes**
**01099 Dresden (DE)**
- **HUANG, Qiang**
**01099 Dresden (DE)**
- **SCHULZE, Benjamin**
**01099 Dresden (DE)**
- **LUSCHTINETZ, Regina**
**01099 Dresden (DE)**
- **GANIER, Jerome**
**01099 Dresden (DE)**
- **RUNGE, Steffen**
**01099 Dresden (DE)**

(74) Representative: **Bittner, Thomas L.**
**Boehmert & Boehmert**
**Anwaltspartnerschaft mbB**
**Pettenkoferstrasse 22**
**80336 München (DE)**

(54) **ORGANIC ELECTROLUMINESCENT ELEMENT AND A DISPLAY DEVICE COMPRISING THE SAME**

(57) The present invention relates to an organic electroluminescent device and to a display device comprising the same.

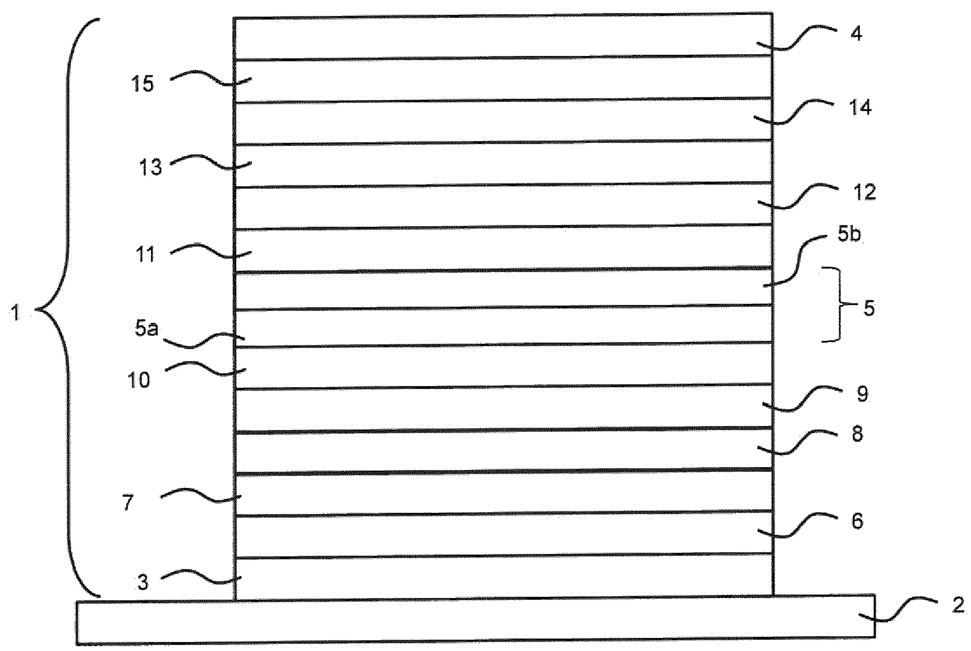


Fig. 1

EP 4 387 413 A1

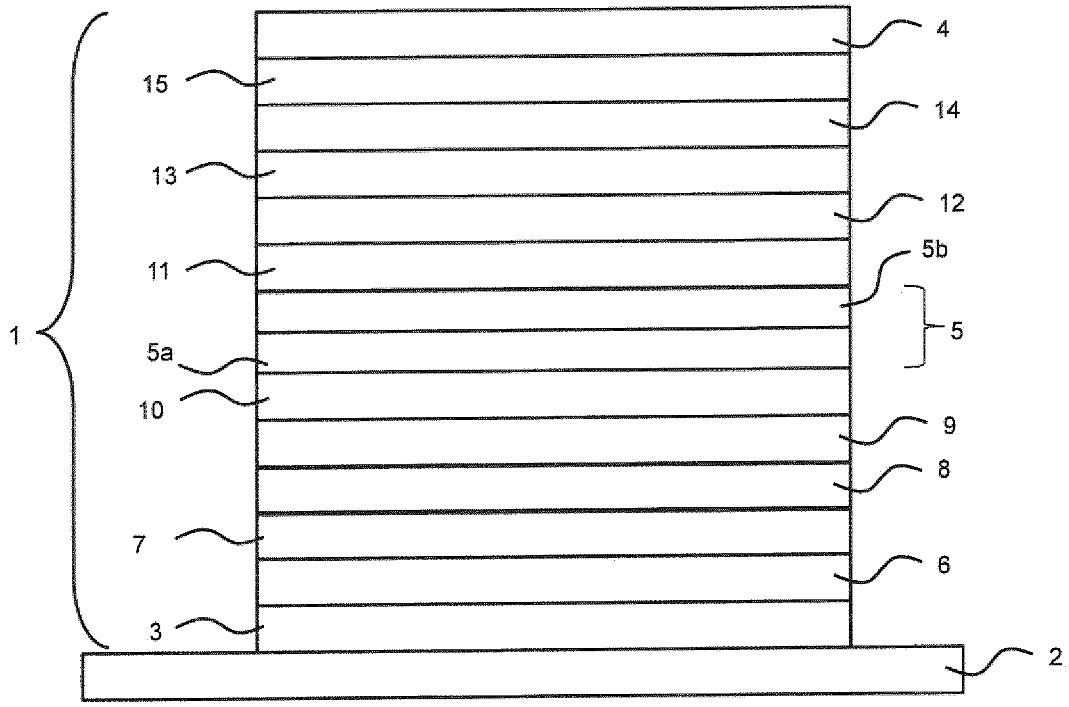


Fig. 1

## Description

TECHNICAL FIELD

The present invention relates to an organic electroluminescent element and to a display device comprising the same.

Organic light-emitting diodes (OLEDs), which are self-emitting devices, have a wide viewing angle, excellent contrast, quick response, high brightness, excellent driving voltage characteristics, and color reproduction. A typical OLED includes an anode, a hole transport layer (HTL), an emission layer (EML), an electron transport layer (ETL), and a cathode, which are sequentially stacked on a substrate. In this regard, the HTL, the EML, and the ETL are thin films formed from organic and / or organometallic compounds.

When a voltage is applied to the anode and the cathode, holes injected from the anode electrode move to the EML, via the HTL, and electrons injected from the cathode electrode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency.

Further known in the art are OLEDs comprising between the two electrodes two or more emission layers. Such OLEDs are called tandem OLEDs. In such tandem OLEDs charge generation layers are comprised between two emission layers, wherein n-type charge generation layers provide electrons to the light emission layer arranged closer to the anode while p-type generation layers provide holes to the light emission layer arranged near the cathode. A variety of materials for preparing such charge generation layers is known in the art.

However, there is still a need to improve the performance of organic electroluminescent devices or materials comprised therein, in particular to improve the performance of (tandem) organic light emitting diodes comprising charge generation layers with respect to operating voltage, efficiency and/or voltage stability.

It is, therefore, the object of the present invention to provide organic electroluminescent devices overcoming the drawbacks of the prior art, in particular to provide organic electroluminescent devices with lowered operating voltage and/or improved efficiency and/or improved voltage stability.

SUMMARY OF THE INVENTION

The above object is achieved by an organic electroluminescent device (OLED, organic light emitting diode) comprising an anode, a cathode, a first electron transport layer, a first emission layer and a charge generation layer; wherein

- the first emission layer, the first electron transport layer and the charge generation layer are arranged between the anode and the cathode;
- the charge generation layer comprises an n-type sub-layer;
- the first electron transport layer is in direct contact with the n-type sub-layer;
- the first electron transport layer is arranged between the first emission layer and the n-type sublayer;
- the first electron transport layer consists of a first electron transport compound comprising a functional group of formula (1)

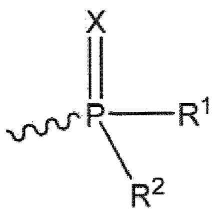
(1)

and a structural moiety selected from $C_6$ to $C_{60}$ arylene and $C_2$ to $C_{60}$ heteroarylaryl, wherein

- X is selected from O, S or Se;

- $R^1$ and $R^2$ are independently selected from substituted or unsubstituted $C_1$ to $C_{16}$ alkyl, wherein the substituent of the substituted $C_1$ to $C_{16}$ alkyl is selected from $C_6$ to $C_{18}$ aryl or $C_2$ to $C_{12}$ heteroaryl;

the wavy line " 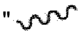 " represents a covalent bond of the P atom of the functional group (1) to the rest of the first electron transport compound;

- the n-type sub-layer comprises a second electron transport compound and a metal;
- wherein the second electron transport compound comprises at least two N-atoms; and
- the metal is selected from the group consisting of alkaline earth metals and rare earth metals.

The object is further achieved by a display device comprising the organic electroluminescent device.
The object is further achieved by compound having formula selected from E7 and E8

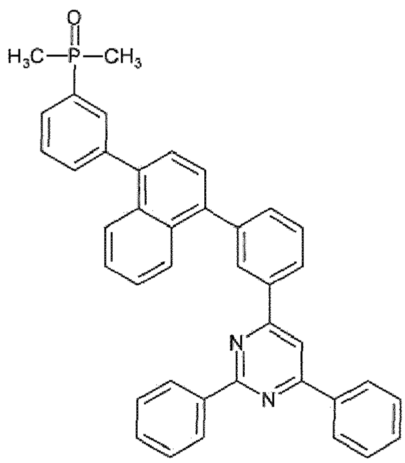
E7

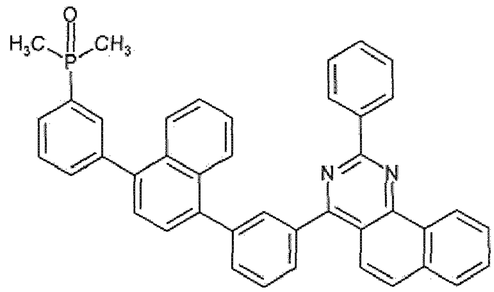
E8.

Organic electroluminescent device

The organic electroluminescent device (= organic light emitting device, OLED) according to the invention comprises an anode, a cathode, a first electron transport layer, a first emission layer, and a charge generation layer. Referring to "a", respectively "an" respective layer does only mean in terms of the present disclosure that the organic light-emitting device comprises at least this layer, that is, at least one of the respective layers. The presence of further layers of the same kind is not excluded. The same applies for further possible layers of the organic electroluminescent device referred to herein if not explicitly mentioned else. Further layers and possible layer arrangements are disclosed below in detail.

First electron transport layer

The first electron transport layer consists of the first electron transport compound, that is, comprises exclusively the first electron transport compound or a mixture of two or more first electron transport compound (compounds meeting the definition of the first electron transport compound in accordance with the present disclosure) but does not comprise any other compounds or materials.
The first electron transport layer may consist of two different first electron transport compounds as defined herein.
Especially, the first electron transport layer is free of an electrical dopant, especially may be free of LiQ. In this regard, "free of" means that respective compounds (electrical dopants) are only contained in the respective layers which cannot be avoided by standard purification methods and common technical means during preparation of the respective layer. In this regards, electrical dopants are in particular, but not limited thereto, electrical n-dopants. The electrical n-dopant may be selected from a metal, alternatively an alkali metal, a metal salt alternatively an alkaline earth metal salt and/or rare earth metal salt, or an organic alkali metal complex, alternatively an alkali metal complex, alternatively LiF, LiCl, LiBr, LiI, LiQ, a metal borate, or mixtures thereof. In particular, the first electron transport layer and the second electron transport layer may be free of an electrical n-dopant. The electrical n-dopant may be a metal salt comprising at least one metal cation and at least one anion. The metal cation of the metal salt may be selected from the group

consisting of alkali metals, alkaline earth metals and rare earth metals, alternatively from the group consisting of Li, Na, K, Rb, Cs, Mg, Ca, Sr, and Ba; alternatively from Li, Mg, Ca, and Sr. The anion of the metal salt may be selected from the group consisting of quinolinolate, phosphine oxide phenolate and borate.

In this regard, electrical n-dopants are in particular, but not limited thereto, an elemental metal, alternatively an electropositive metal selected from alkali metals, alkaline earth metals, rare earth metals and transition metals, transition metals; a metal salt, alternatively an alkali metal salt, alkaline earth metal salt and/or rare earth metal salt, or a metal complex, alternatively an alkali metal complex, alkaline earth metal complex, transition metal complex and/or rare earth metal complex. Examples of n-doping metal salts can be LiF, LiCl, LiBr, LiI, metal borates, metal quinolinolates or mixtures thereof. Further examples of electrical n-dopants are strong chemical reducing agents. This class of "redox" n-dopants may be generically characterized by energy level of the highest occupied molecular orbital (HOMO) comparable with lowest unoccupied molecular orbital Energy Level of corresponding electron transport matrices, which is in usual OLED transport materials about -3.0 eV or less. It is to be understood that the term "about -3.0 eV or less" means less negative values than -3.0 eV, for example -2.8 eV, -2.5 eV, -2.3 eV, -2.1 eV or vales less negative than -2.0 eV.

Electrical n-dopants may be organic compounds as disclosed in EP1837926A1, WO07107306A1 or WO07107356A1.

The first electron transport layer is in direct contact with the n-type sub-layer.

First electron transport compound

The first electron transport compound a (at least one) functional group of formula (1)

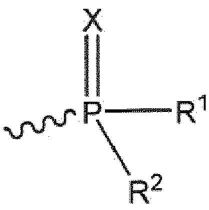

(1).

and a structural moiety selected from $C_6$ to $C_{60}$ heteroarylene and $C_2$ to $C_{60}$ arylene.

The wavy line " 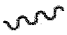 " represents a covalent bond of the P atom of the functional group (1) to the rest of the first electron transport compound. For example, if the first electron transport compound consists of one functional group of formula (1) and one structural moiety selected from $C_6$ to $C_{60}$ heteroarylene and $C_2$ to $C_{60}$ arylene then the direct bond represented by 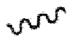 is formed between the functional group of formula (1) and the structural moiety.

X is selected from O, S or Se. X may be selected from O or S. X may be O.

$R^1$ and $R^2$ are independently selected from substituted or unsubstituted $C_1$ to $C_{16}$ alkyl. That is, the PO moiety is directly linked (via P) to two $sp^3$ hybridized C atoms. $R^1$ and $R^2$ may be independently selected from substituted or unsubstituted $C_1$ to $C_{14}$ alkyl. $R^1$ and $R^2$ may be independently selected from substituted or unsubstituted $C_1$ to $C_{12}$ alkyl. $R^1$ and $R^2$ may be independently selected from substituted or unsubstituted $C_1$ to $C_{10}$ alkyl. $R^1$ and $R^2$ may be independently selected from substituted or unsubstituted $C_1$ to $C_8$ alkyl. $R^1$ and $R^2$ may be independently selected from substituted or unsubstituted $C_1$ to $C_6$ alkyl. $R^1$ and $R^2$ may be independently selected from substituted or unsubstituted $C_1$ to $C_5$ alkyl. $R^1$ and $R^2$ may be independently selected from substituted or unsubstituted $C_1$ to $C_4$ alkyl. $R^1$ and $R^2$ may be independently selected from substituted or unsubstituted $C_1$ to $C_3$ alkyl. $R^1$ and $R^2$ may be independently selected from substituted or unsubstituted $C_1$ to $C_2$ alkyl. $R^1$ and $R^2$ may be independently selected from substituted or unsubstituted $C_1$ alkyl (methyl).

The substituent(s) of the substituted alkyl is/are selected from $C_6$ to $C_{18}$ aryl or $C_2$ to $C_{12}$ heteroaryl. The substituent(s) of the substituted alkyl may be selected from $C_6$ to $C_{12}$ aryl or $C_2$ to $C_{11}$ heteroaryl. The substituent(s) of the substituted alkyl may be selected from $C_6$ to $C_{19}$ aryl or $C_2$ to $C_9$ heteroaryl. The substituent(s) of the substituted alkyl may be selected from $C_6$ aryl or $C_2$ to $C_{12}$ heteroaryl.

$R^1$ and $R^2$ are independently selected from unsubstituted $C_1$ to $C_{16}$ alkyl. $R^1$ and $R^2$ may be independently selected from unsubstituted $C_1$ to $C_{14}$ alkyl. $R^1$ and $R^2$ may be independently selected from unsubstituted $C_1$ to $C_{12}$ alkyl. $R^1$ and $R^2$ may be independently selected from unsubstituted $C_1$ to $C_{10}$ alkyl. $R^1$ and $R^2$ may be independently selected from unsubstituted $C_1$ to $C_8$ alkyl. $R^1$ and $R^2$ may be independently selected from unsubstituted $C_1$ to $C_6$ alkyl. $R^1$ and $R^2$ may be independently selected from unsubstituted $C_1$ to $C_5$ alkyl. $R^1$ and $R^2$ may be independently selected from unsubstituted $C_1$ to $C_4$ alkyl. $R^1$ and $R^2$ may be independently selected from unsubstituted $C_1$ to $C_3$ alkyl. $R^1$ and $R^2$ may be independently selected from unsubstituted $C_1$ to $C_2$ alkyl. $R^1$ and $R^2$ may be independently selected from unsubstituted $C_1$ alkyl.

The first electron transport compound comprises a structural moiety selected from $C_6$ to $C_{60}$ aryl or $C_2$ to $C_{60}$ heteroaryl. The structural moiety may be selected from $C_{12}$ to $C_{54}$ aryl or $C_8$ to $C_{54}$ heteroaryl. The structural moiety may be selected from $C_{18}$ to $C_{54}$ aryl or $C_{14}$ to $C_{54}$ heteroaryl. The structural moiety may be selected from $C_{24}$ to $C_{54}$ aryl or $C_{20}$ to $C_{54}$ heteroaryl. The structural moiety may be selected from $C_{30}$ to $C_{54}$ aryl or $C_{26}$ to $C_{54}$ heteroaryl.

The structural moiety selected from $C_6$ to $C_{60}$ aryl or $C_2$ to $C_{60}$ heteroaryl of the first electron transport compound may comprise 6 to 10 aromatic and/or heteroaromatic 6-membered rings. The structural moiety selected from $C_6$ to $C_{60}$ aryl or $C_2$ to $C_{60}$ heteroaryl of the first electron transport compound may comprise 6 to 9 aromatic and/or heteroaromatic 6-membered rings. The structural moiety selected from $C_6$ to $C_{60}$ aryl or $C_2$ to $C_{60}$ heteroaryl of the first electron transport compound may comprise 7 or 8 aromatic and/or heteroaromatic 6-membered rings.

The structural moiety selected from $C_6$ to $C_{60}$ aryl or $C_2$ to $C_{60}$ heteroaryl of the first electron transport compound may comprise at least two condensed aromatic and/or heteroaromatic 6-membered rings. The structural moiety selected from $C_6$ to $C_{60}$ aryl or $C_2$ to $C_{60}$ heteroaryl of the first electron transport compound may comprise at least one structural moiety consisting of two or three condensed aromatic and/or heteroaromatic 6-membered rings. The structural moiety selected from $C_6$ to $C_{60}$ aryl or $C_2$ to $C_{60}$ heteroaryl of the first electron transport compound may comprise at least one structural moiety consisting of two or three condensed aromatic 6-membered rings.

The first electron transport compound may have the formula (2)

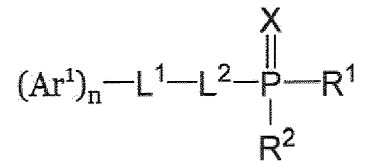

(2).

In Formula (2), X is selected from O, S or Se. X may be selected from O or S. X may be O.

In Formula (2), $R^1$ and $R^2$ are independently selected from substituted or unsubstituted $C_1$ to $C_{16}$ alkyl. That is, the PO moiety is directly linked (via P) to two $sp^3$ hybridized C atoms. $R^1$ and $R^2$ may be independently selected from substituted or unsubstituted $C_1$ to $C_{14}$ alkyl. $R^1$ and $R^2$ may be independently selected from substituted or unsubstituted $C_1$ to $C_{12}$ alkyl. $R^1$ and $R^2$ may be independently selected from substituted or unsubstituted $C_1$ to $C_{10}$ alkyl. $R^1$ and $R^2$ may be independently selected from substituted or unsubstituted $C_1$ to $C_8$ alkyl. $R^1$ and $R^2$ may be independently selected from substituted or unsubstituted $C_1$ to $C_6$ alkyl. $R^1$ and $R^2$ may be independently selected from substituted or unsubstituted $C_1$ to $C_5$ alkyl. $R^1$ and $R^2$ may be independently selected from substituted or unsubstituted $C_1$ to $C_4$ alkyl. $R^1$ and $R^2$ may be independently selected from substituted or unsubstituted $C_1$ to $C_3$ alkyl. $R^1$ and $R^2$ may be independently selected from substituted or unsubstituted $C_1$ to $C_2$ alkyl. $R^1$ and $R^2$ may be independently selected from substituted or unsubstituted $C_1$ alkyl.

The substituent(s) of the substituted alkyl is/are selected from $C_6$ to $C_{18}$ aryl or $C_2$ to $C_{12}$ heteroaryl. The substituent(s) of the substituted alkyl may be selected from $C_6$ to $C_{12}$ aryl or $C_2$ to $C_{11}$ heteroaryl. The substituent(s) of the substituted alkyl may be selected from $C_6$ to $C_{19}$ aryl or $C_2$ to $C_9$ heteroaryl. The substituent(s) of the substituted alkyl may be selected from $C_6$ aryl or $C_2$ to $C_{12}$ heteroaryl.

$R^1$ and $R^2$ may be independently selected from unsubstituted $C_1$ to $C_{16}$ alkyl. $R^1$ and $R_2$ may be independently selected from unsubstituted $C_1$ to $C_{14}$ alkyl. $R^1$ and $R^2$ may be independently selected from unsubstituted $C_1$ to $C_{12}$ alkyl. $R^1$ and $R^2$ may be independently selected from unsubstituted $C_1$ to $C_{10}$ alkyl. $R^1$ and $R^2$ may be independently selected from unsubstituted $C_1$ to $C_8$ alkyl. $R^1$ and $R^2$ may be independently selected from unsubstituted $C_1$ to $C_6$ alkyl. $R^1$ and $R^2$ may be independently selected from unsubstituted $C_1$ to $C_5$ alkyl. $R^1$ and $R^2$ may be independently selected from unsubstituted $C_1$ to $C_4$ alkyl. $R^1$ and $R^2$ may be independently selected from unsubstituted $C_1$ to $C_3$ alkyl. $R^1$ and $R^2$ may be independently selected from unsubstituted $C_1$ to $C_2$ alkyl. $R^1$ and $R^2$ may be independently selected from unsubstituted $C_1$ alkyl.

n is 1 or 2.

$Ar^1$ is selected from the group consisting of unsubstituted or substituted $C_6$ to $C_{60}$ aryl and $C_2$ to $C_{60}$ heteroaryl. $Ar^1$ may be selected from the group consisting of unsubstituted or substituted $C_6$ to $C_{60}$ aryl and $C_2$ to $C_{60}$ heteroaryl. $Ar^1$ may be selected from the group consisting of unsubstituted or substituted $C_6$ to $C_{54}$ aryl and $C_2$ to $C_{54}$ heteroaryl. $Ar^1$ may be selected from the group consisting of unsubstituted or substituted $C_6$ to $C_{48}$ aryl and $C_2$ to $C_{48}$ heteroaryl. $Ar^1$ may be selected from the group consisting of unsubstituted or substituted $C_6$ to $C_{42}$ aryl and $C_2$ to $C_{42}$ heteroaryl. $Ar^1$ may be selected from the group consisting of unsubstituted or substituted $C_6$ to $C_{36}$ aryl and $C_2$ to $C_{36}$ heteroaryl. $Ar^1$ may be selected from the group consisting of unsubstituted or substituted $C_6$ to $C_{30}$ aryl and $C_2$ to $C_{30}$ heteroaryl. $Ar^1$ may be selected from the group consisting of unsubstituted or substituted $C_6$ to $C_{24}$ aryl and $C_2$ to $C_{24}$ heteroaryl. $Ar^1$ may be selected from the group consisting of unsubstituted or substituted $C_{10}$ to $C_{24}$ aryl and $C_7$ to $C_{24}$ heteroaryl. $Ar^1$ may be selected from the group consisting of unsubstituted or substituted $C_{10}$ to $C_{18}$ aryl and $C_9$ to $C_{20}$ heteroaryl.

$Ar^1$ may be selected from the group consisting of unsubstituted or substituted $C_{10}$ to $C_{14}$ aryl and $C_9$ to $C_{18}$ heteroaryl. $Ar^1$ may be independently selected from the group consisting of naphthyl and pyrimidine

The substituent(s) of $Ar_1$, that is, of the substituted $C_2$ to $C_{60}$ heteroaryl, respectively the $C_6$ to $C_6$. aryl, is/are independently selected from D, $C_1$ to $C_{12}$ alkyl, $C_1$ to $C_{12}$ alkoxy, CN, OH, halogen, $C_6$ to $C_{32}$ aryl or $C_2$ to $C_{25}$ heteroaryl, preferably from H and $C_1$ to $C_4$ alkyl.

$Ar^1$ may be selected from the group consisting of the following structures

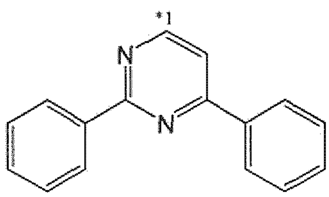 ; 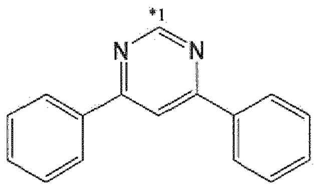 ; 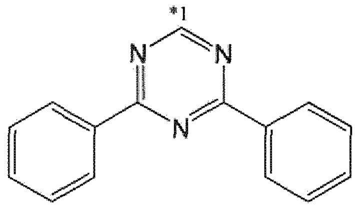 ;

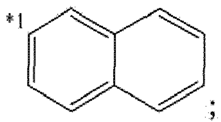 ; 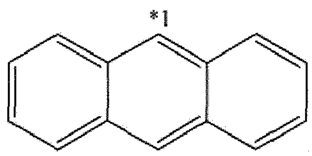 ; 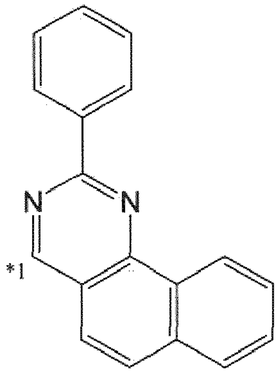 ; 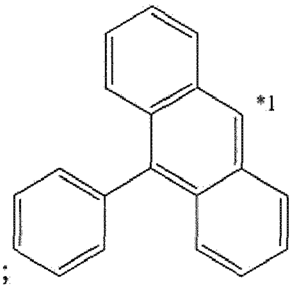

and

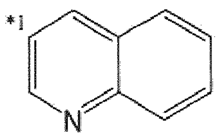 ,

wherein $Ar^1$ is bonded at *1 to $L^1$.

$L^1$ may be substituted or unsubstituted $C_6$ to $C_{36}$ arylene. $L^1$ may be substituted or unsubstituted $C_{10}$ to $C_{30}$ arylene. $L^1$ may be substituted or unsubstituted $C_{12}$ to $C_{26}$ arylene.

Substituent(s) of the substituted $C_6$ to $C_{36}$ arylene, is/are independently selected from D, $C_1$ to $C_{12}$ alkyl, $C_1$ to $C_{12}$ alkoxy, CN, OH, halogen, $C_6$ to $C_{32}$ aryl or $C_2$ to $C_{25}$ heteroaryl, preferably from D and $C_1$ to $C_4$ alkyl.

$L^1$ may be selected from biphenyl-diyl, terphenyl-diyl, or analogs wherein in the analoges one or more of the phenyl rings of the biphenyl-diyl, respectively the terphenyl-diyl, is replaced by a ring-system comprising two or more, such as two or three, annelated benzene rings, that is, a ring system, such as naphthylene or anthracenylene.

$L^1$ may be selected from the following structures

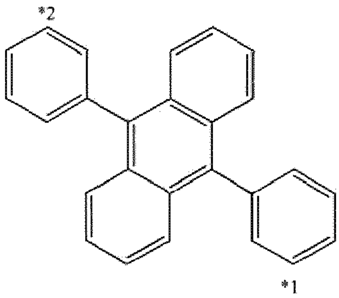 ; 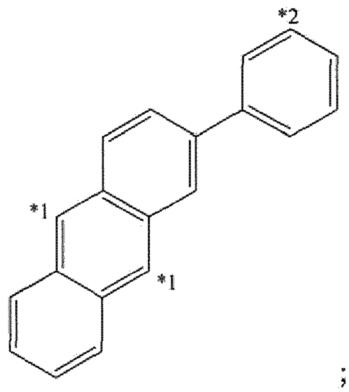 ; 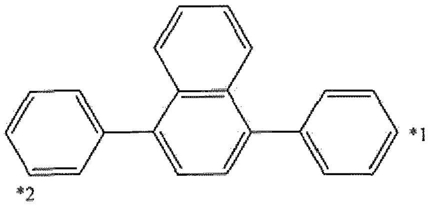 ;

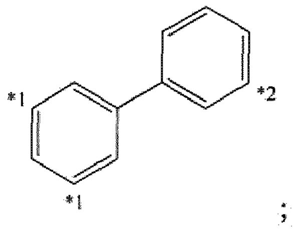 ; 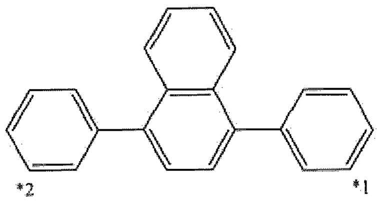 ;

wherein $L^1$ is bonded to $Ar^1$ at *1 and $L^1$ is bonded to $L^2$ at *2.

$L^2$ is selected from a single bond or $C_1$ to $C_6$ alkyl. $L^2$ may be a single bond.

The compound of formula (1) or (2) may be selected from E1 to E8

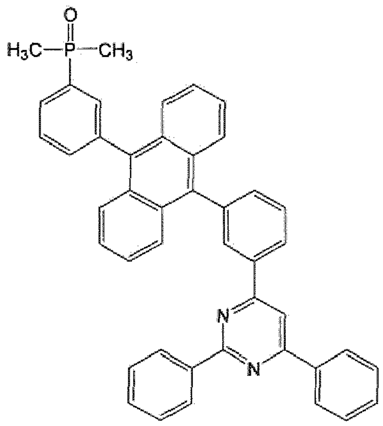
E1

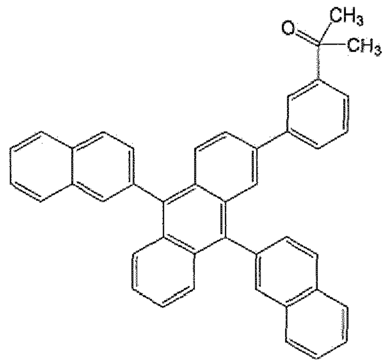
E2

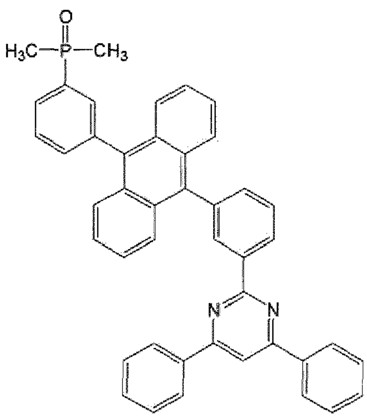
E3

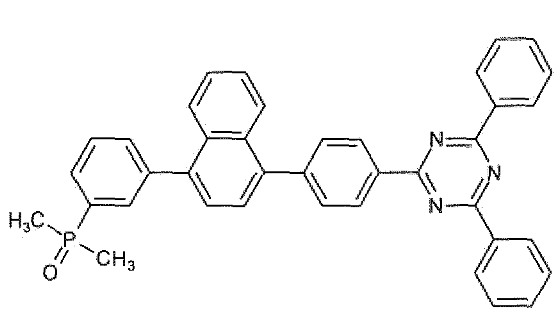
E4

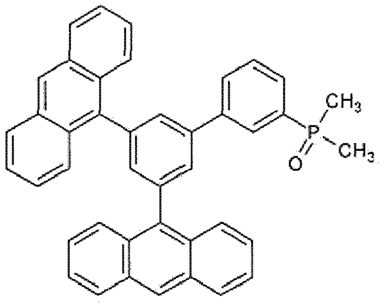

E5

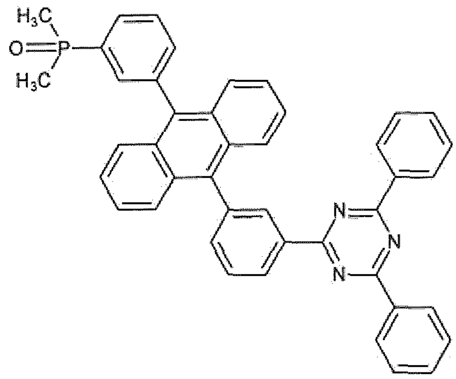

E6

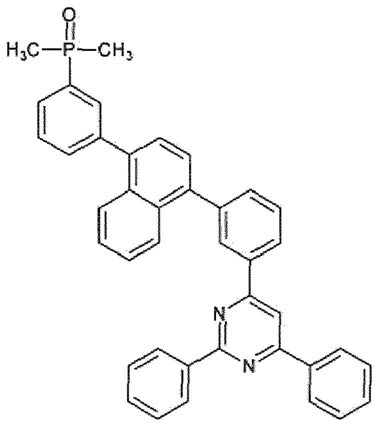

E7

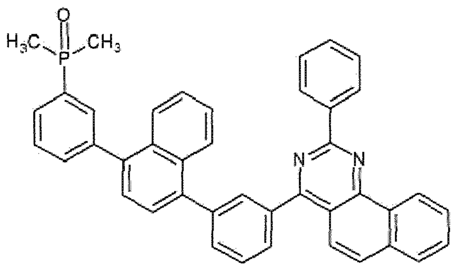

E8.

The first electron transport compound may be different from the second electron transport compound.

The first electron transport layer may consist of only one first electron transport compound, that is molecules having the same structural formula.

Charge generation layer

The most important use of charge generation layers is in tandem OLEDs. In this case, the charge generation layer is arranged between the first emission layer and the second emission layer. The charge generation layer comprises a n-type sublayer (n-doped sub-layer; n-type charge generation layer). The charge generation layer may further comprise a p-doped sublayer (p-type sublayer). The n-type sublayer provides electrons to the light emission layer arranged closer to the anode while the p-type sublayer provides holes to the light emission layer arranged near the cathode.

The n-type sublayer comprises a metal. The metal is selected from the group consisting of alkaline earth metals and rare earth metals, such as Mg, Ca, Sr, Ba, Eu and Yb, in particular Mg, Ca, Sr and Yb, especially Yb, or mixtures of two or more of the foregoing. The metal comprised in the n-doped sublayer is an n-dopant, that is, an electrical dopant improving the transport of electrons in the sublayer. Preferably, the metal is a rare earth metal, most preferred Yb. The metal is present in the n-type sublayer in its (substantially) elemental form, that is, has an oxidation number of o (zero) and is not present in the form of a metal salt or a metal complex.

The n-doped sublayer further comprises second electron transport compound which may be considered as a n-type matrix material. The second electron transport compound may be the predominant material in the n-doped sublayer, that is, may be comprised in an amount selected from the group consisting of at least 50 wt.%, at least 60 wt.%, at least 70 wt.%, at least 80 wt.%, at least 90 wt.%, at least 95 wt.%, at least 98 wt.%, at least 99 wt.%, with respect to the total weight of n-type sub-layer.

The n-type sub-layer may comprise only one kind of second electron transport compound. If the n-type sub-layer may comprise only one kind of second electron transport compound, the second electron transport compound may comprise only one non-condensed pyridine moiety.

The n-type sub-layer is in direct contact with the first electron transport layer.

Second electron transport compound

The second electron transport compound comprises at least two N-atoms.

According to an embodiment, the second electron transport compounds is selected from formula (xxa) or formula (xxb):

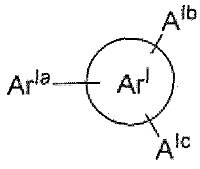
(xxa)

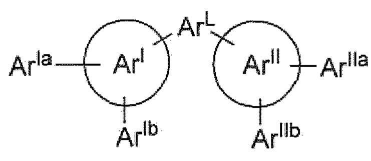
(xxb)

wherein $Ar^{I}$ is a substituted or unsubstituted $C_3$ to $C_{40}$ heteroaromatic ring system comprising at least one nitrogen atom, preferably at least two nitrogen atoms in case of xxa,

wherein $Ar^{II}$ is substituted or unsubstituted $C_3$ to $C_{40}$ heteroaromatic ring system comprising at least one nitrogen atom,

wherein the substituents on $Ar^{I}$ and $Ar^{II}$ are, identically or differently on each occurrence, D, a monovalent aromatic or heteroaromatic ring system having 5 to 6o aromatic ring atoms, which may in each case be substituted by one or more radicals $R^a$;

wherein $Ar^{Ia}$, $Ar^{Ib}$, $Ar^{Ic}$, $Ar^{IIa}$, and $Ar^{IIb}$ are, identically or differently on each occurrence, H, D, a monovalent aromatic or heteroaromatic ring system having 5 to 60 aromatic ring atoms, which may in each case be substituted by one or more radicals $R^a$;

wherein at least one of $Ar^{Ia}$, $Ar^{Ib}$, $Ar^{Ic}$ in formula (xxa) and in case of formula (II) at least one of

$Ar^{Ia}$, $Ar^{Ib}$, $Ar^{IIa}$, and $Ar^{IIb}$ is independently selected from a monovalent aromatic or heteroaromatic ring system having 5 to 60 aromatic ring atoms, which may in each case be substituted by one or more radicals $R^a$;

wherein $Ar^{L}$ is a divalent aromatic or heteroaromatic ring system having 5 to 60 aromatic ring atoms, which is optionally substituted by one or more radicals $R^a$;

wherein $R^a$ is on each occurrence, identically or differently, H, D, F, Cl, Br, I, CHO, $N(R^b)_2$, $N(Ar^{1s})_2$, $B(Ar^{1s})_2$, $C(=O)Ar^{1s}$, $P(=Y)(R^c)_2$, $S(=O)Ar^{1s}$, $S(=O)_2Ar^{1s}$, $CR^b{=}CR^bAr^{1s}$, CN, $NO_2$, $Si(R^b)_3$, $B(OR^b)_2$, $B(R^b)_2$, $B(N(R^b)_2)_2$, $OSO_2R^b$, a substituted or unsubstituted straight-chain $C_1$ to $C_{20}$ alkyl, a substituted or unsubstitutedstraight-chain $C_1$ to $C_{20}$ alkenyl, a substituted or unsubstituted straight-chain $C_1$ to $C_{20}$ alkynyl, a substituted or unsubstituted straight-chain $C_1$ to $C_{20}$ alkoxy, a substituted or unsubstituted straight-chain $C_1$ to $C_{20}$ thioalkoxy, substituted or unsubstituted branched $C_3$ to $C_{20}$ alkyl, a substituted or unsubstituted branched $C_3$ to $C_{20}$ alkenyl, a substituted or unsubstituted branched $C_3$ to $C_{20}$ a substituted or unsubstituted branched $C_3$ to $C_{20}$ alkynyl, a substituted or unsubstituted branched $C_3$ to $C_{20}$ alkoxy or a substituted or unsubstituted $C_3$ to $C_{20}$ branched thioalkoxy,substituted or unsubstituted cyclic $C_3$ to $C_{40}$ alkyl, substituted or unsubstituted cyclic $C_3$ to $C_{40}$ alkenyl, substituted or unsubstituted cyclic $C_3$ to $C_{40}$ alkinyl, substituted or unsubstituted cyclic $C_3$ to $C_{40}$ alkoxy or substituted or unsubstituted cyclic $C_3$ to $C_{40}$ thioalkoxy;substituted or unsubstituted heterocyclic $C_3$ to $C_{40}$ alkyl, substituted or unsubstituted heterocyclic $C_3$ to $C_{40}$ alkenyl, substituted or unsubstituted heterocyclic $C_3$ to $C_{40}$ alkynyl, substituted or unsubstituted heterocyclic $C_3$ to $C_{40}$ alkoxy or substituted or unsubstituted heterocyclic $C_3$ to $C_{40}$ thioalkoxy; wherein the one or more substituents, if present, is selected from $R^b$, where one or more non-adjacent $CH_2$ groups is optionally replaced by $R^bC{=}CR^b$, C≡C, $Si(R^b)_2$, $Ge(R^b)_2$, $Sn(R^b)_2$, C=O, C=S, C=Se, $C{=}NR^b$, $P(=O)(R^b)$, SO, $SO_2$, $NR^b$, O, S or $CONR^b$ and where one or more H atoms is optionally replaced by D, F, Cl, Br, I, CN or $NO_2$, or an aromatic or heteroaromatic ring system having 5 to 60 aromatic ring atoms, which may in each case be substituted by one or more radicals $R^b$, or an aryloxy or heteroaryloxy group having 5 to 60 aromatic ring atoms, which is optionally substituted by one or more radicals $R^b$, or a combination of these systems; two or more adjacent substituents $R^a$ here optionally forms a mono- or polycyclic, aliphatic or aromatic ring system with one another;

wherein $Ar^{1s}$ is on each occurrence, identically or differently, an aromatic or heteroaromatic ring system having 5 to 30 aromatic ring atoms, which is optionally substituted by one or more radicals $R^b$; two radicals $Ar^{1s}$ here which are bonded to the same nitrogen, phosphorus or boron atom may also be linked to one another by a single bond or a bridge selected from $B(R^b)$, $C(R^b)_2$, $Si(R^b)_2$, C=O, $C=NR^b$, $C=C(R^b)_2$, O, S, S=O, $SO_2$, $N(R^b)$, $P(R^b)$ and $P(=Y)R^c$;

wherein $R^b$ is on each occurrence, identically or differently, H, D or a $C_1$ to $C_{20}$ aliphatic hydrocarbyl, a $C_1$ to $C_{20}$ aryl and/or $C_1$ to $C_{20}$ heteroaryl, in which, in addition, H atoms is optionally replaced by D or F; two or more adjacent substituents $R^b$ here may also form a mono- or polycyclic, aliphatic or aromatic ring system with one another;

wherein Y is selected from O, S or Se, preferably O, and $R^c$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy;

For the purposes of this invention, an aromatic or heteroaromatic ring system is intended to be taken to mean a system which does not necessarily contain only one aryl or one heteroaryl group or only aryl or heteroaryl groups, but instead in which a plurality of aryl or heteroaryl groups may also be interrupted by a short non-aromatic unit (preferably less than 10 percent of the atoms other than H), such as, for example, an $sp^3$-hybridised C, N or O atom. Thus, for example, systems such as 9,9'-spirobifluorene, 9,9-diarylfluorene, triarylamine, diaryl ether, stilbene, benzophenone, etc., are also intended to be taken to mean aromatic ring systems for the purposes of this invention. Likewise, an aromatic or heteroaromatic ring system is taken to mean systems in which a plurality of aryl or heteroaryl groups are linked to one another by single bonds, for example biphenyl, terphenyl or bipyridine.

According to one embodiment, $Ar^I$ is selected from pyrazine, pyridine, pyrimidine, or triazine, phenanthroline.

According to one embodiment, $Ar^{II}$ is selected from pyrazine, pyridine, pyrimidine, or triazine, phenanthroline.

According to one embodiment, $Ar^I$ in formula (xxa) or (xxxa) is selected from pyrazine, pyridine, pyrimidine, triazine, phenanthroline; or $Ar^I$ in formula (xxa) or (xxxa) and $Ar^{II}$ in formula (xxb) or (xxxb) are independently of each other selected from pyrazine, pyridine, pyrimidine, triazine, or phenanthroline.

According to an embodiment, wherein the compound comprising at least one nitrogen atom in a six-member aromatic ring in the electron transport layer is selected from formula (xxxa) or formula (xxxb):

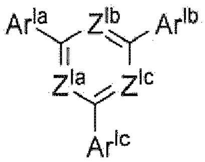

(xxxa)

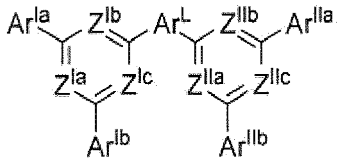

(xxxb)

wherein

$Z^{Ia}$ is selected from N or CH,

$Z^{Ib}$ is selected from N or CH,

$Z^{Ic}$ is selected from N or CH,

$Z^{IIa}$ is selected from N or CH,

$Z^{IIb}$ is selected from N or CH, and

$Z^{IIc}$ is selected from N or CH,

wherein in formula (XXxa) at least one of $Z^{Ia}$, $Z^{Ib}$ and $Z^{Ic}$ is selected from N,

wherein in formula (XXxb) at least one of $Z^{Ia}$, $Z^{ib}$, $Z^{Ic}$, $Z^{IIa}$, $Z^{IIb}$, and $Z^{IIc}$ is selected from N,

wherein $Ar^{Ia}$, $Ar^{Ib}$, $Ar^{Ic}$, $Ar^{IIa}$ and $Ar^{IIb}$ are identically or differently on each occurrence, a monovalent aromatic or heteroaromatic ring system having 5 to 60 aromatic ring atoms, which may in each case be substituted by one or more radicals $R^a$;

wherein $Ar^L$ is a divalent aromatic or heteroaromatic ring system having 5 to 6o aromatic ring atoms, which is optionally substituted by one or more radicals $R^a$,

wherein $R^a$ is on each occurrence, identically or differently, H, D, F, Cl, Br, I, CHO, $N(R^b)_2$, $N(Ar^{1s})_2$, $B(Ar^{1s})_2$, $C(=O)Ar^{1s}$, $P(=Y)(R^c)_2$, $S(=O)Ar^{1s}$, $S(=O)_2Ar^{1s}$, $CR^b=CR^bAr^{1s}$, CN, $NO_2$, $Si(R^b)_3$, $B(OR^b)_2$, $B(R^b)_2$, $B(N(R^b)_2)_2$, $OSO_2R^b$, a substituted or unsubstituted straight-chain $C_1$ to $C_{20}$ alkyl, a substituted or unsubstitutedstraight-chain $C_1$ to $C_{20}$ alkenyl, a substituted or unsubstituted straight-chain $C_1$ to $C_{20}$ alkynyl, a substituted or unsubstituted straight-chain $C_1$ to $C_{20}$ alkoxy, a substituted or unsubstituted straight-chain $C_1$ to $C_{20}$ thioalkoxy, substituted or unsubstituted branched $C_3$ to $C_{20}$ alkyl, a substituted or unsubstituted branched $C_3$ to $C_{20}$ alkenyl, a substituted or unsubstituted branched $C_3$ to $C_{20}$ a substituted or unsubstituted branched $C_3$ to $C_{20}$ alkynyl, a substituted or unsubstituted branched $C_3$ to $C_{20}$ alkoxy or a substituted or unsubstituted branched $C_3$ to $C_{20}$ thioalkoxy,substituted or unsubstituted cyclic $C_3$ to $C_{40}$ alkyl, substituted or unsubstituted cyclic $C_3$ to $C_{40}$ alkenyl, substituted or unsubstituted cyclic $C_3$ to $C_{40}$ alkinyl, substituted or unsubstituted cyclic $C_3$ to $C_{40}$ alkoxy or substituted or unsubstituted cyclic $C_3$ to $C_{40}$ thioalkoxy;substituted or unsubstituted heterocyclic $C_3$ to $C_{40}$ alkyl, substituted or unsubstituted heterocyclic $C_3$ to $C_{40}$ alkenyl, substituted or unsubstituted heterocyclic $C_3$ to $C_{40}$ alkynyl, substituted or unsubstituted heterocyclic $C_3$ to $C_{40}$ alkoxy or substituted or unsubstituted heterocyclic $C_3$ to $C_{40}$ thioalkoxy;

wherein the one or more substituents, if present, is selected from $R^b$, where one or more non-adjacent $CH_2$ groups is optionally replaced by $R^bC=CR^b$, C≡C, $Si(R^b)_2$, $Ge(R^b)_2$, $Sn(R^b)_2$, C=O, C=S, C=Se, $C=NR^b$, $P(=O)(R^b)$, SO, $SO_2$, $NR^b$, O, S or $CONR^b$ and where one or more H atoms is optionally replaced by D, F, Cl, Br, I, CN or $NO_2$, or an aromatic or heteroaromatic ring system having 5 to 60 aromatic ring atoms, which may in each case be substituted by one or more radicals $R^b$, or an aryloxy or heteroaryloxy group having 5 to 6o aromatic ring atoms, which is optionally substituted by one or more radicals $R^b$, or a combination of these systems; two or more adjacent substituents $R^a$ here optionally forms a mono- or polycyclic, aliphatic or aromatic ring system with one another;

wherein $Ar^{1s}$ is on each occurrence, identically or differently, an aromatic or heteroaromatic ring system having 5 to 30 aromatic ring atoms, which is optionally substituted by one or more radicals $R^b$; two radicals $Ar^{1s}$ here which are bonded to the same nitrogen, phosphorus or boron atom may also be linked to one another by a single bond or a bridge selected from $B(R^b)$, $C(R^b)_2$, $Si(R^b)_2$, C=O, $C=NR^b$, $C=C(R^b)_2$, O, S, S=O, $SO_2$, $N(R^b)$, $P(R^b)$ and $P(=Y)R^c$;

wherein $R^b$ is on each occurrence, identically or differently, H, D or a $C_1$ to $C_{20}$ aliphatic hydrocarbyl, a $C_1$ to $C_{20}$ aryl and/or $C_1$ to $C_{20}$ heteroaryl, in which, in addition, H atoms is optionally replaced by D or F; two or more adjacent substituents $R^b$ here may also form a mono- or polycyclic, aliphatic or aromatic ring system with one another;

wherein Y is selected from O, S or Se, preferably O, and $R^c$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy.

For the purposes of this invention, an aromatic or heteroaromatic ring system is intended to be taken to mean a system which does not necessarily contain only aryl or heteroaryl groups, but instead in which a plurality of aryl or heteroaryl groups may also be interrupted by a short non-aromatic unit (preferably less than 10 percent of the atoms other than H), such as, for example, an $sp^3$-hybridised C, N or O atom. Thus, for example, systems such as 9,9'-spirobifluorene, 9,9-diarylfluorene, triarylamine, diaryl ether, stilbene, benzophenone, etc., are also intended to be taken to mean aromatic ring systems for the purposes of this invention. Likewise, an aromatic or heteroaromatic ring system is taken to mean systems in which a plurality of aryl or heteroaryl groups are linked to one another by single bonds, for example biphenyl, terphenyl or bipyridine.

The second electron transport compound may comprise a moiety consisting of 2 to 6 condensed aromatic rings. The second electron transport compound may comprise a moiety consisting of 2 to 5 condensed aromatic rings. The second electron transport compound may comprise a moiety consisting of 2 to 4 condensed aromatic rings. The second electron transport compound may comprise a moiety consisting of 2 or 3 condensed aromatic rings.

The second electron transport compound may comprise an arene moiety consisting of 2 to 6 condensed aromatic rings. The second electron transport compound may comprise an arene moiety consisting of 2 to 5 condensed aromatic rings. The second electron transport compound may comprise an arene moiety consisting of 2 to 4 condensed aromatic rings. The second electron transport compound may comprise an arene moiety consisting of 2 or 3 condensed aromatic rings. The arene moiety is selected from the group consisting of naphthalene, anthracene, phenanthrene and pyrene, preferably is anthracene.

The second electron transport compound may comprise 7 to 10 aromatic, 5- or 6-membered rings. The second electron transport compound may comprise 8 or aromatic, 5- or 6-membered rings.

The second electron transport compound may have a molecular weight from 400 to 1,800 g/mol.

The second electron transport compound may comprise a heteroarene moiety selected from the group consisting of azine, diazine, triazine, azole, diazole, azanaphtalene, diazanaphtalene, azaanthracene, diazaanthracene, azaphenanthrene, diazaphenanthrene.

The second electron transport compound may comprise a heteroarene moiety selected from the group consisting of diazine, diazole, benzimidazole, imidazopyridine, phenanthroline, quinazoline. benzoquinazoline and quinoxaline, wherein the respective heteroarene moiety is unsubstituted or substituted with $C_6$ to $C_{18}$ aryl or $C_2$ to $C_{12}$ heteroaryl, wherein the $C_6$ to $C_{18}$ aryl or $C_2$ to $C_{12}$ heteroaryl may be substituted with one or more independently selected from $C_1$ to $C_4$ alkyl, respectively.

The second electron transport compound may be selected from the following compounds F6 to F9.

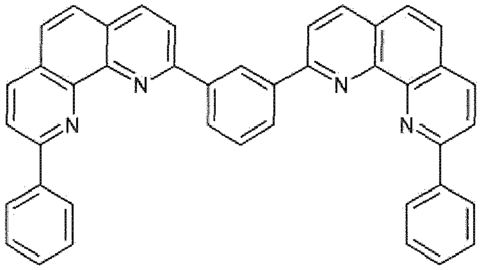

F6

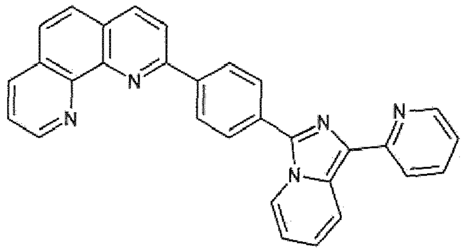

F7

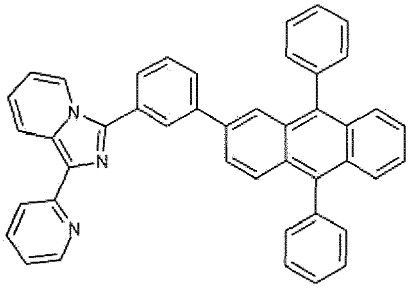

F8

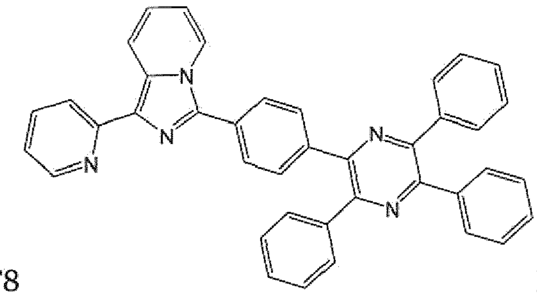

F9.

It may be provided that the second electron transport compound does not comprise a dialkyl phosphine oxide structural moiety.

It may be provided that the second electron transport compound does not comprise another metal chelating structural moiety except for pyridyl-imidazopyridine or phenanthroline.

## Second emission layer

The organic electroluminescent device may comprise a second emission layer. The charge generation layer may be arranged between the first emission layer and the second emission layer. The second emission layer may be arranged closer to the cathode than the first emission layer.

## First hole blocking layer

The organic electroluminescent device may further comprise a first hole blocking layer arranged between the first electron transport layer and the first emission layer.

## Second electron transport layer

The organic electroluminescent device may further comprise a second electron transport layer. The second electron transport layer may be arranged between the second emission layer and the cathode. The second electron transport layer comprises a second electron transport material. The second emission layer is arranged closer to the cathode than the first emission layer.

In one embodiment, the second electron transport layer is in direct contact with (contacting sandwiched between) the first electron transport layer and with the first emission layer.

The first electron transport material and the second electron transport material may comprise the same electron transport matrix compound or mixture of electron matrix compounds, especially one or more electron transport matrix compounds as defined above in one or more embodiments and combinations thereof for the first electron transport

matrix compound.

The second electron transport layer may comprise an electrical dopant. In this regards, electrical dopants are in particular, but not limited thereto, electrical n-dopants. The electrical n-dopant may be selected from a metal, alternatively an alkali metal, a metal salt alternatively an alkaline earth metal salt and/or rare earth metal salt, or an organic alkali metal complex, alternatively an alkali metal complex, alternatively LiF, LiCl, LiBr, LiI, LiQ, a metal borate, or mixtures thereof. In particular, the first electron transport layer and the second electron transport layer may be free of an electrical n-dopant. The electrical n-dopant may be a metal salt comprising at least one metal cation and at least one anion. The metal cation of the metal salt may be selected from the group consisting of alkali metals, alkaline earth metals, and rare earth metals, alternatively from the group consisting of Li, Na, K, Rb, Cs, Mg, Ca, Sr, and Ba; alternatively from Li, Mg, Ca, and Sr. The anion of the metal salt may be selected from the group consisting of quinolinolate, phosphine oxide phenolate and borate. Especially, the electrical dopant may be LiQ.

In this regard, electrical n-dopants are in particular, but not limited thereto, an elemental metal, alternatively an electropositive metal selected from alkali metals, alkaline earth metals, rare earth metals and transition metals, transition metals; a metal salt, alternatively an alkali metal salt, alkaline earth metal salt and/or rare earth metal salt, or a metal complex, alternatively an alkali metal complex, alkaline earth metal complex, transition metal complex and/or rare earth metal complex. Examples of n-doping metal salts can be LiF, LiCl, LiBr, LiI, metal borates, metal quinolinolates or mixtures thereof. Further examples of electrical n-dopants are strong chemical reducing agents. This class of "redox" n-dopants may be generically characterized by energy level of the highest occupied molecular orbital (HOMO) comparable with lowest unoccupied molecular orbital Energy Level of corresponding electron transport matrices, which is in usual OLED transport materials about -3.0 eV or less. It is to be understood that the term "about -3.0 eV or less" means less negative values than -3.0 eV, for example -2.8 eV, -2.5 eV, -2.3 eV, -2.1 eV or vales less negative than -2.0 eV.

Electrical n-dopants may be organic compounds as disclosed in EP1837926A1, WO07107306A1 or WO07107356A1.

The second electron transport layer may comprise the first electron transport compound comprising a functional group of formula (1) as a matrix material. The second electron transport layer may comprise the same first electron transport compound comprising a functional group of formula (1) forming the first electron transport layer as a matrix material.

## Electron injection layer

The organic light emitting device may further comprise an electron injection layer and the electron injection layer may be arranged between the second electron transport layer and the cathode.

The second electron transport layer may be in direct contact with the electron injection layer. The second electron transport layer may be in direct contact with the cathode. The electron injection layer may be contacting sandwiched between the second electron transport layer and the cathode.

The electron injection layer may comprise a metal, alternatively an alkali metal, a metal salt alternatively an alkaline earth metal salt and/or rare earth metal salt, or an organic alkali metal complex, alternatively an alkali metal complex, alternatively LiF, LiCl, LiBr, LiI, LiQ, a metal borate, or mixtures thereof. Especially, the electron injection layer may comprise Yb.

The electron injection layer may consist of a metal, alternatively an alkali metal, a metal salt alternatively an alkaline earth metal salt and/or rare earth metal salt, or an organic alkali metal complex, alternatively an alkali metal complex, alternatively LiF, LiCl, LiBr, LiI, LiQ, a metal borate, or mixtures thereof. Especially, the electron injection layer may consist of Yb.

## Further layers

In accordance with the invention, the organic light emitting device may comprise, besides the layers already mentioned above, further layers. Exemplary embodiments of respective layers are described in the following:

### *Substrate*

The substrate may be any substrate that is commonly used in manufacturing organic light emitting device. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

*Anode electrode*

Either the first electrode or the second electrode may be an anode electrode. The anode electrode may be formed by depositing or sputtering a material that is used to form the anode electrode. The material used to form the anode electrode may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide ($SnO_2$), aluminum zinc oxide (AlZO) and zinc oxide (ZnO), may be used to form the anode electrode. The anode electrode may also be formed using metals, typically silver (Ag), gold (Au), or metal alloys.

*Hole injection layer*

The hole injection layer (HIL) may be formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500°C, a pressure of $10^{-8}$ to $10^{-3}$ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

In such a case, the HIL may be a pure layer of p-dopant or may be selected from a hole-transporting matrix compound doped with a p-dopant. Typical examples of known redox doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; α-NPD (N,N'-Bis(naphthalen-1-yl)-N,N'-bis(phenyl)-benzidine) doped with F4TCNQ. α-NPD doped with 2,2'-(perfluoronaphthalen-2,6-diylidene) dimalononitrile (PD1). α-NPD doped with 2,2',2"-(cyclopropane-1,2,3-triylidene)tris(2-(p-cyanotetrafluorophenyl)acetonitrile) ($PD_2$). Dopant concentrations can be selected from 1 to 20 wt.-%, more preferably from 3 wt.-% to 10 wt.-%.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

*Hole transport layer*

The hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed by any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

*Electron blocking layer*

The function of the electron blocking layer (EBL) is to prevent electrons from being transferred from the emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.
The electron blocking layer may comprise a compound of formula Z below (Z).

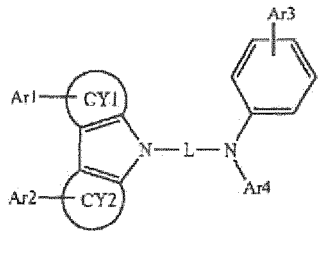

(Z).

In Formula Z, CY1 and CY2 are the same as or different from each other, and each independently represent a benzene cycle or a naphthalene cycle, Ar1 to Ar3 are the same as or different from each other, and each independently selected from the group consisting of hydrogen; a substituted or unsubstituted aryl group having 6 to 30 carbon atoms; and a substituted or unsubstituted heteroaryl group having 5 to 30 carbon atoms, Ar4 is selected from the group consisting of a substituted or unsubstituted phenyl group, a substituted or unsubstituted biphenyl group, a substituted or unsubstituted terphenyl group, a substituted or unsubstituted triphenylene group, and a substituted or unsubstituted heteroaryl group having 5 to 30 carbon atoms, L is a substituted or unsubstituted arylene group having 6 to 30 carbon atoms.
If the electron blocking layer has a high triplet level, it may also be described as triplet control layer.
The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

*Emission layer (EML)*

The at least two EMLs may be formed independently on HTLs by vacuum deposition, spin coating, slot-die coat-ing, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.
The respective emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA), bis(2-(2-hydroxyphenyl)benzo-thiazolate)zinc ($Zn(BTZ)_2$), $EML_3$ below, Compound 1 below, and Compound 2 below.

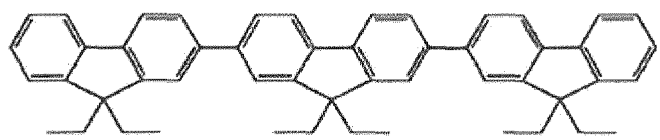

$EML_3$

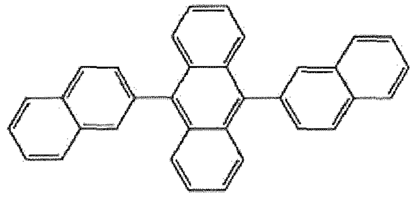

ADN

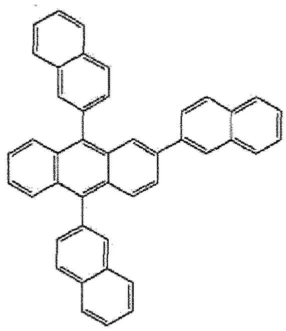

Compound 1

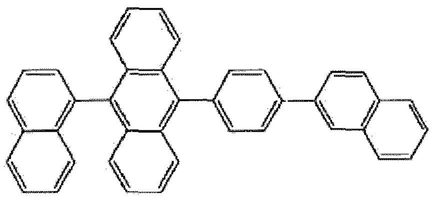

Compound 2

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, $Ir(piq)_3$, and $Btp_2Ir(acac)$, but are not limited thereto. These compounds are phosphorescent emitters, however, fluorescent red emitter dopants could also be used.

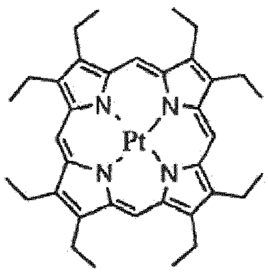

PtOEP

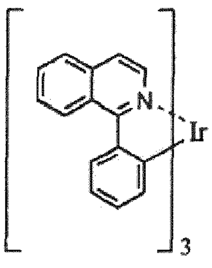

$Ir(piq)_3$

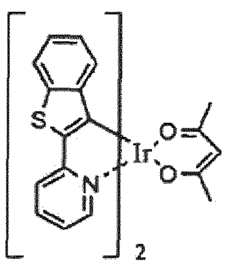

$Btp_2Ir(acac)$

Examples of phosphorescent green emitter dopants are $Ir(ppy)_3$ (ppy = phenylpyridine), $Ir(ppy)_2(acac)$, $Ir(mpyp)_3$ are shown below. Compound 3 is an example of a fluorescent green emitter and the structure is shown below.

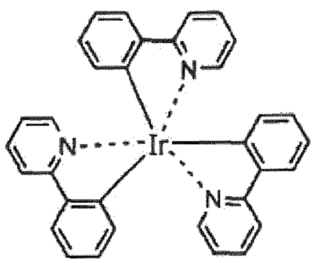

$Ir(ppy)_3$

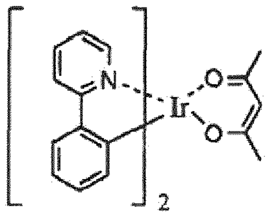

$Ir(ppy)_2(acac)$

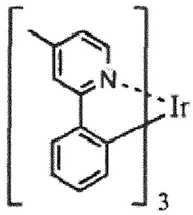

$Ir(mpyp)_3$

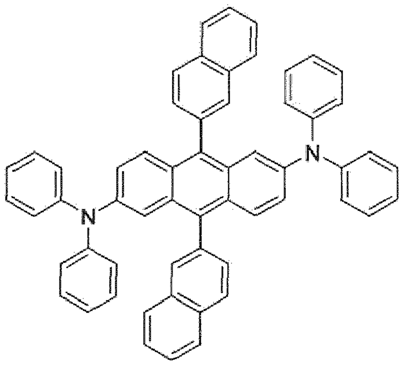

Compound 3

Examples of phosphorescent blue emitter dopants are F2Irpic, (F2ppy)2Ir(tmd) and $Ir(dfppz)_3$, ter-fluorene, the structures are shown below. 4.4'-bis(4-diphenyl amiostyryl)biphenyl (DPAVBi), 2,5,8,11-tetra-tert-butyl perylene (TBPe), and Compound 4 below are examples of fluorescent blue emitter dopants.

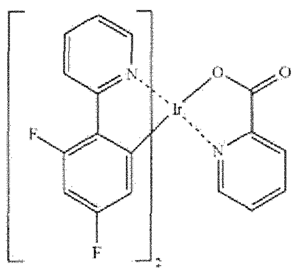

F2Irpic

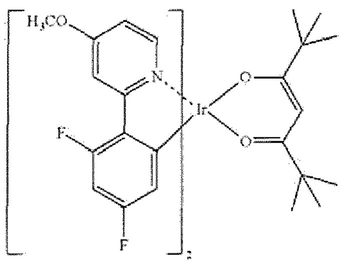

(F2ppy)2Ir(tmd)

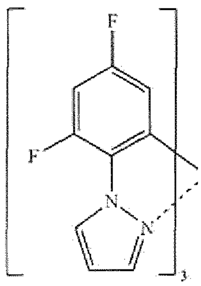

Ir(dfppz)3

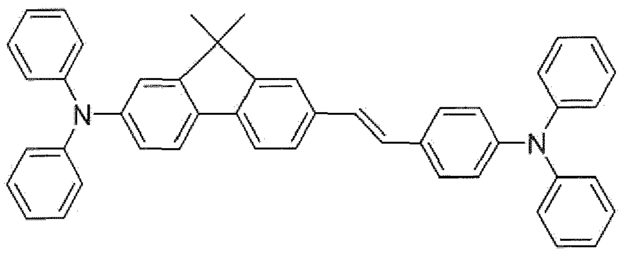

Compound 4

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

*Hole blocking layer (HBL)*

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, and phenanthroline derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

*Electron transport layer (ETL)*

The OLED according to the present invention may contain further electron transport layers (ETLs).

According to various embodiments the OLED may comprise an electron transport layer or an electron transport layer stack comprising at least a first electron transport sub-layer and at least a second electron transport sub-layer.

By suitably adjusting energy levels of particular layers of the ETL, the injection and transport of the electrons may be controlled, and the holes may be efficiently blocked. Thus, the OLED may have long lifetime.

The electron transport layer of the organic light emitting device may comprise an organic electron transport matrix (ETM) material. Further, the electron transport layer may comprise one or more n-dopants. Suitable compounds for the ETM are not particularly limited. In one embodiment, the electron transport matrix compounds consist of covalently bound atoms. Preferably, the electron transport matrix compound comprises a conjugated system of at least 6, more preferably of at least 10 delocalized electrons. In one embodiment, the conjugated system of delocalized electrons may be comprised in aromatic or heteroaromatic structural moieties, as disclosed e.g. in documents EP 1 970 371 A1 or WO 2013/079217 A1.

In one embodiment, the electron transport layer may be electrically doped with an electrical n-dopant. In another embodiment, the electron transport layer may comprise the second electron transport sub-layer which is arranged closer to the cathode than the first electron transport sub-layer and only the second electron transport sub-layer may comprise the electrical n-dopant.

The electrical n-dopant may be selected from electropositive elemental metals, and/or from metal salts and metal complexes of electropositive metals, particularly from elemental forms, salts and/or complexes of metal selected from alkali metals, alkaline earth metals, and rare earth metals.

*Electron injection layer (EIL)*

The optional EIL, which may facilitates injection of electrons from the cathode, may be formed on the ETL, preferably directly on the electron transport layer. Examples of materials for forming the EIL include lithium 8-hydroxyquinolinolate (LiQ), LiF, NaCl, CsF, $Li_2O$, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

*Cathode electrode*

The cathode electrode is formed on the EIL if present. The cathode electrode may be formed of a metal, an alloy, an electrically conductive compound, or a mixture thereof. The cathode electrode may have a low work function. For example, the cathode electrode may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like.

Alternatively, the cathode electrode may be formed of a transparent conductive oxide, such as ITO or IZO. The cathode may comprise more that 50 volume % of metal selected from Ag and Au.

The thickness of the cathode electrode may be in the range from about 5 nm to about 1000 nm, for example, in the range from about 10 nm to about 100 nm. When the thickness of the cathode electrode is in the range from about 5 nm to about 50 nm, the cathode electrode may be transparent or semitransparent even if formed from a metal or metal alloy.

The cathode may be a semitransparent metal cathode having a thickness less than 20 nm, preferably less than 15 nm, even more preferably less than 12 nm.

It is to be understood that the cathode electrode is not part of an electron injection layer or the electron transport layer.

*Charge generation layer/hole generation layer*

The charge generation layer (CGL) is composed of a double layer.

The charge generation layer is a pn junction joining an n-type charge generation layer (electron generation layer) and a p-type charge generation layer (hole generation layer). The n-side of the pn junction generates electrons and injects them into the layer which is adjacent in the direction to the anode. Analogously, the p-side of the p-n junction generates holes and injects them into the layer which is adjacent in the direction to the cathode.

Charge generation layers are used in tandem devices, for example, in tandem OLEDs comprising, between two electrodes, two or more emission layers. In a tandem OLED comprising two emission layers, the n-type charge generation layer provides electrons for the first light emission layer arranged near the anode, while the p-type charge generation layer provides holes to the second light emission layer arranged between the first emission layer and the cathode.

The hole generation layer can be composed of an organic matrix material doped with p-type dopant. Suitable matrix materials for the hole generation layer may be materials conventionally used as hole injection and/or hole transport matrix materials. Also, p-type dopant used for the hole generation layer can employ conventional materials. For example, the p-type dopant can be one selected from a group consisting of tetrafluore-7,7,8,8-tetracyanoquinodimethane (F4-TCNQ), derivatives of tetracyanoquinodimethane, radialene derivatives, iodine, FeCl3, FeF3, and SbCl5. Also, the host can be one selected from a group consisting of N,N'-di(naphthalen-1-yl)-N,N-diphenyl-benzidine (NPB), N,N'-diphenyl-N,N'-bis(3-methylphenyl)-1,1-biphenyl-4,4'-diamine (TPD) and N,N',N'-tetranaphthyl-benzidine (TNB).

In accordance with the invention, at least one n-type charge generation layer comprised in the inventive organic light emitting device is the n-type sub-layer defined herein. In case that the organic light emitting device comprises more than one n-type charge generation layers (= n-type sub-layer), it is only provided that at least one of these n-type charge generation layers is as defined therein.

In a preferred embodiment, n-type charge generation layer comprises of a) a first organic compound b) a second organic compound and c) a zero-valent metal dopant, wherein the zero-valent metal dopant is a metal selected from the group consisting of alkali metals, alkaline earth metals, rare earth metals, group 3 transition metals and mixtures thereof. Alternatively comprising of a) the first organic compound, wherein the first organic compound is a compound comprising at least one P=X group, wherein X is selected from O, S or Se; b) the second organic compound, and the second organic compound comprises at least one metal complexing group, alternatively two metal complexing groups and c) a zero-valent metal dopant, wherein the zero-valent metal dopant is a metal selected from the group consisting of alkali metals, alkaline earth metals, rare earth metals, group 3 transition metals and mixtures thereof.

In a preferred embodiment, n-type charge generation layer consisting of, a) a first organic compound b) a second organic compound and c) a zero-valent metal dopant, wherein the zero-valent metal dopant is a metal selected from the group consisting of alkali metals, alkaline earth metals, rare earth metals, group 3 transition metals and mixtures thereof. Alternatively consisting of a) the first organic compound, wherein the first organic compound is a compound comprising at least one P=X group, wherein X is selected from O, S or Se; b) the second organic compound, and the second organic compound comprises at least one metal complexing group, alternatively two metal complexing groups and c) a zero-valent metal dopant, wherein the zero-valent metal dopant is a metal selected from the group consisting of alkali metals, alkaline earth metals, rare earth metals, group 3 transition metals and mixtures thereof.

In a preferred embodiment, n-type charge generation layer may comprises the first organic compound and the second organic compound in a wt.-% ratio from 05:95 to 50:50, 10:90 to 50:50, 20:80 to 50:50 or 30:70 to 50:50 preferably 10:90 to 50:50, 20:80 to 50:50 or 30:70 to 50:50.

In a preferred embodiment, n-type charge generation layer may comprises the first organic compound and the second organic compound in a wt.-% ratio from 95:05 to 50:50, 90:10 to 50:50, 80:20 to 50:50 or 70:30 to 50:50 preferably 90:10 to 50:50, 80:20 to 50:50 or 70:30 to 50:50.

Alternatively, it can be provided that other n-type charge generation layers (besides the at least one) are formed differently. If the n-type charge generation layer is not a n-type sub-layer as defined therein, the n-type charge generation

layer can be layer of a neat n-dopant, for example of an electropositive metal, or can consist of an organic matrix material doped with the n-dopant. In one embodiment, the n-type dopant can be alkali metal, alkali metal compound, alkaline earth metal, or alkaline earth metal compound. In another embodiment, the metal can be one selected from a group consisting of Li, Na, K, Rb, Cs, Mg, Ca, Sr, Ba, La, Ce, Sm, Eu, Tb, Dy, and Yb. More specifically, the n-type dopant can be one selected from a group consisting of Cs, K, Rb, Mg, Na, Ca, Sr, Eu and Yb. Suitable matrix materials for the electron generating layer may be the materials conventionally used as matrix materials for electron injection or electron transport layers. The matrix material can be for example one selected from a group consisting of triazine compounds, hydroxyquinoline derivatives like tris(8-hydroxyquinoline)aluminum, benzazole derivatives, and silole derivatives.

In one embodiment, the p-type charge generation layer may include compounds of the following Chemical Formula X.

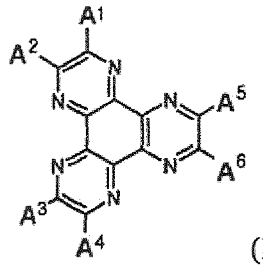

(X),

wherein each of A1 to A6 may be hydrogen, a halogen atom, nitrile (-CN), nitro (-$NO_2$), sulfonyl (-SO2R), sulfoxide (-SOR), sulfonamide (-SO2NR), sulfonate (-SO3R), trifluoromethyl (-CF3), ester (-COOR), amide (-CONHR or -CONRR'), substituted or unsubstituted straight-chain or branched-chain C1-C12 alkoxy, substituted or unsubstituted straight-chain or branched-chain C1-C12 alkyl, substituted or unsubstituted straight-chain or branched chain C2-C12 alkenyl, a substituted or unsubstituted aromatic or non-aromatic heteroring, substituted or unsubstituted aryl, substituted or unsubstituted mono- or di-arylamine, substituted or unsubstituted aralkylamine, or the like. Herein, each of the above R and R' may be substituted or unsubstituted C1-C60 alkyl, substituted or unsubstituted aryl, or a substituted or unsubstituted 5- to 7-membered heteroring, or the like.

An example of such p-type charge generation layer may be a layer comprising CNHAT

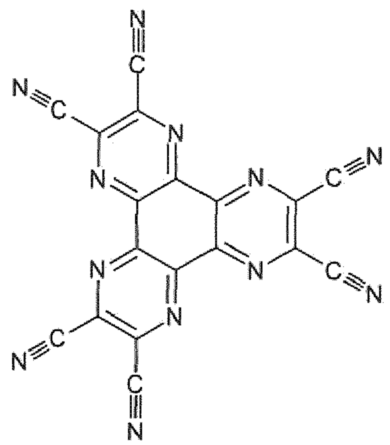

(CNHAT).

The hole generating layer may be arranged on top of the n-type charge generation layer.

With regard to the method for producing the organic electronic device, the alternative embodiments outlined above may be applied mutatis mutandis. For example, the charge generation layer may be produced with an interlayer provided between the n-type sub-layer, and the p-type sub-layer.

According to one aspect, the OLED according to the present invention can comprise a layer structure of a substrate that is adjacent arranged to an anode electrode, the anode electrode is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to a first electron transport layer, the first electron transport layer is adjacent arranged to an n-type charge generation layer (n-type sub-layer), the n-type charge generation layer is adjacent arranged to a hole generating layer (p-type sub-layer), an interlayer may be provided between the n-type

sub-layer, and the p-type sub-layer, the hole generating layer is adjacent arranged to a second hole transport layer, the second hole transport layer is adjacent arranged to a second electron blocking layer, the second electron blocking layer is adjacent arranged to a second emission layer, between the second emission layer and the cathode electrode an optional electron transport layer and/or an optional injection layer are arranged.

The stack of layers may be produced by techniques known in the art as such. For example, one or more layers in the stack may be produced by vacuum thermal evaporation.

With regard to the method of producing the organic electronic device, the depositing of the plurality of layers may comprise a step of depositing the p-type sub-layer, the depositing comprising evaporation and deposition of the fullerene compound in vacuum. Preferably, all layers are deposited in vacuum.

Details and Definitions of the invention

An organic compound as referred to herein is generally any chemical compound that contains carbon (except some compounds generally referred to as being inorganic, such as carbonates, cyanides, carbon dioxide, diamond etc.). The term organic compound used herein also encompasses compounds such as organometallic compounds, for example metallocenes etc.

The term "zero-valent" as used herein refers to a metal in the oxidation state o, i.e. particular to metals from which no electron has been removed. The zero-valent metal may be present in the form of zero-valent atoms, neat metal, alloys etc.

The term "trivalent" as used herein refers to a nitrogen atom with a single bond and a double bond and containing a lone pair of electrons.

The term "metal complexing group" as used herein refers to a group which can form a bond with a metal ion.

The term "hydrocarbyl group" as used herein shall be understood to encompass any organic group comprising carbon atoms, in particular organic groups, such as alkyl, aryl, heteroaryl, heteroalkyl, in particular such groups which are substituents usual in organic electronics.

The term "conjugated system" as used herein refer to a system of alternating $\pi$- and $\sigma$-bonds or a molecule having alternating single and multiple bonds i.e. double bond or a system having one or more two-atom structural units having the $\pi$-bond between its atoms can be replaced by an atom bearing at least one lone electron pair, typically by a divalent O or S atom.

The term "alkyl" as used herein shall encompass linear as well as branched and cyclic alkyl. For example, $C_3$-alkyl may be selected from n-propyl and iso-propyl. Likewise, $C_4$-alkyl encompasses n-butyl, sec-butyl and t-butyl. Likewise, C6-alkyl encompasses n-hexyl and cyclohexyl.

The subscribed number n in Cn relates to the total number of carbon atoms in the respective alkyl, arylene, heteroarylene or aryl group.

The term "aryl" as used herein shall encompass phenyl (C6-aryl), fused aromatics, such as naphthalene, anthracene, phenanthrene, tetracene etc. Further encompassed are biphenyl and oligo- or polyphenyls, such as terphenyl etc. Further encompassed shall be any further aromatic hydrocarbon substituents, such as fluorenyl etc. Arylene, respectively heteroarylene refers to groups to which two further moieties are attached.

The term "heteroaryl" as used herein refers to aryl groups in which at least one carbon atom is substituted by a heteroatom, preferably selected from N, O, S, B or Si.

The term "halogenated" refers to an organic compound in which one hydrogen atom thereof is replaced by a halogen atom. The term "perhalogenated" refers to an organic compound in which all of the hydrogen atoms thereof are replaced by halogen atoms. The meaning of the terms "fluorinated" and "perfluorinated" should be understood analogously.

The subscripted number n in Cn-heteroaryl merely refers to the number of carbon atoms excluding the number of heteroatoms. In this context, it is clear that a $C_3$ heteroarylene group is an aromatic compound comprising three carbon atoms, such as pyrazol, imidazole, oxazole, thiazole and the like.

In terms of the invention, the expression "between" with respect to one layer being between two other layers does not exclude the presence of further layers which may be arranged between the one layer and one of the two other layers. In terms of the invention, the expression "in direct contact" with respect to two layers being in direct contact with each other means that no further layer is arranged between those two layers. One layer deposited on the top of another layer is deemed to be in direct contact with this layer.

In the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about $\geq$ 380 nm to about $\leq$ 780 nm.

With respect to the inventive organic light emitting device, the compounds mentioned in the experimental part may be most preferred.

The organic electroluminescent device (OLED) may be a bottom- or top-emission device.

Another aspect is directed to a device comprising at least one organic electroluminescent device (OLED). A device comprising organic light-emitting diodes is for example a display or a lighting panel.

In the present invention, the following defined terms, these definitions shall be applied, unless a different definition is given in the claims or elsewhere in this specification.

In the context of the present specification the term "different" or "differs" in connection with the matrix material means that the matrix material differs in their structural formula.

The energy levels of the highest occupied molecular orbital, also named HOMO, and of the lowest unoccupied molecular orbital, also named LUMO, are measured in electron volt (eV).

The terms "OLED" and "organic light-emitting diode" are simultaneously used and have the same meaning. The term "organic electroluminescent device" as used herein may comprise both organic light emitting diodes as well as organic light emitting transistors (OLETs).

As used herein, "weight percent", "wt.-%", wt%, "percent by weight", "% by weight", and variations thereof refer to a composition, component, substance or agent as the weight of that component, substance or agent of the respective electron transport layer divided by the total weight of the respective electron transport layer thereof and multiplied by 100. It is understood that the total weight percent amount of all components, substances and agents of the respective electron transport layer and electron injection layer are selected such that it does not exceed 100 wt.-%.

As used herein, "volume percent", "vol.-%", "percent by volume", "% by volume", and variations thereof refer to a composition, component, substance or agent as the volume of that component, substance or agent of the respective electron transport layer divided by the total volume of the respective electron transport layer thereof and multiplied by 100. It is understood that the total volume percent amount of all components, substances and agents of the cathode layer are selected such that it does not exceed 100 vol.-%.

All numeric values are herein assumed to be modified by the term "about", whether or not explicitly indicated. As used herein, the term "about" refers to variation in the numerical quantity that can occur. Whether or not modified by the term "about" the claims include equivalents to the quantities.

It should be noted that, as used in this specification and the appended claims, the singular forms "a", "an", and "the" include plural referents unless the content clearly dictates otherwise.

The term "free of", "does not contain", "does not comprise" does not exclude impurities. Impurities have no technical effect with respect to the object achieved by the present invention.

## BRIEF DESCRIPTION OF THE DRAWINGS

These and/or other aspects and advantages of the present invention will become apparent and more readily appreciated from the following description of the exemplary embodiments, taken in conjunction with the accompanying drawings, of which:

Fig. 1 is a schematic representation of a layer stack of a tandem organic light emitting diode device;

Fig. 2 is schematic representations of a layer stack of another tandem organic light emitting diode device;

Fig. 3 is a schematic representation of a layer stack of a further tandem organic light emitting diode device.

## DETAILED DESCRIPTION

Reference will now be made in detail to the exemplary embodiments of the present invention, examples of which are illustrated in the accompanying drawings, wherein like reference numerals refer to the like elements throughout. The exemplary embodiments are described below, in order to explain the aspects of the present invention, by referring to the figures.

Herein, when a first element is referred to as being formed or disposed "on" a second element, the first element can be disposed directly on the second element or one or more other elements may be disposed there between. When a first element is referred to as being formed or disposed "directly on" a second element, no other elements are disposed there between.

In Fig. 1, a first hole injection layer 6, a first hole transport layer 7, and a first electron blocking layer 8 are provided between the anode 3 and a first emitting layer 9. A first electron transport layer 10 is provided between the first emitting layer 9 and the charge generation layer 5 (n-type sublayer 5a and p-type sublayer 5b). A second hole injection layer 11, second hole transport layer 12, and second electron blocking layer 13 are provided between the charge generation layer 5 and a second emitting layer 14. A second electron transport layer 15 is provided between the second emitting layer 14 and the cathode 4.

Fig. 2 shows a schematic representation of another tandem OLED. The stack of layers 1 provided on the substrate 2, in addition, comprises an interlayer 16 between n-type sublayer 5a and p-type sublayer 5b.

Fig. 3 shows a schematic representation of a further tandem OLED. In the stack of layers 1 provided on the substrate 2 the n-type sublayer 5a of the charge generation layer 5 comprises a first n-type sublayer 5a1 and a second n-type sublayer 5a2. In an alternative embodiment (not shown), the charge generation layer 5 of the tandem OLED in Fig. 5 may comprise the interlayer 16.

Hereinafter, one or more exemplary embodiments of the present invention will be described in detail with, reference to the following examples. However, these examples are not intended to limit the purpose and scope of the one or more exemplary embodiments of the present invention.

## Experimental part

### Preparation of inventive new compounds

**Dimethyl(3-(4-(3-(2-phenylbenzo[h]quinazolin-4-yl)phenyl)naphthalen-1-yl)phenyl)phosphine oxide (E7)**

In a nitrogen flushed flask, 4-(3-(dimethylphosphoryl)phenyl)naphthalen-1-yl trifluoromethanesulfonate (50.0 g, 116.72 mmol) and 2,4-diphenyl-6-(3-(4,4,5,5-tetramethyl-1,3,2-dioxaborolan-2-yl)phenyl)pyrimidine (65.9 g, 152 mmol, 1.3 eq.) were dissolved with $Pd(PPh_3)_4$ (0.12 mmol, 1.35 g, 0.01 eq.) and $K_2CO_3$ (32.3 g, 234 mmol, 2.0 eq.) in a mixture of deaerated toluene, ethanol and water. The reaction mixture was heated at reflux for five hours. After cooling to room temperature, the phases were separated; the organic phase was washed with brine and filtered through a gel pad of Florisil with toluene. After removing half of the solvent, the product was precipitated with cyclohexane. The precipitate was filtered off by suction filtration and washed with cyclohexane. The crude product was then recrystallized in toluene/ethanol. The purified solid was isolated as a fine powder after sublimation, with HPLC purity 99.95%.

**2-phenyl-4-(3-(4,4,5,5-tetramethyl-1,3,2-dioxaborolan-2-yl)phenyl)benzo[h]quinazoline**

A flask was flushed with nitrogen and equipped with 4-(3-bromophenyl)-2-phenylbenzo[h]quinazoline (CAS 1502825-34-4, 45.0 g, 109.41 mmol) and 4,4,4',4',5,5,5',5'-octamethyl-2,2'-bi(1,3,2-dioxaborolane) (CAS 73183-34-3, 33.34 g, 131.29 mmol, 1.2 eq.). The starting materials were dissolved with [1,1'-Bis(diphenylphosphino)ferrocene]dichloropalladium(II) (CAS 72287-26-4, 2.4 g, 3.28 mmol, 0.03 eq.) and KOAc (26.8 g, 273.53 mmol, 2.05eq.) in dry dimethylformamide. The reaction mixture was stirred at reflux overnight. After cooling down to room temperature, solvent was removed in vacuo and the product was dissolved in dichlormethane. The organic phase was washed twice with water and dried over $Na_2SO_4$. After filtration through a gel pad of Florisil the product was precipitated with cyclohexane. After filtration, the product was isolated as a fine solid, with HPLC purity 99.17%.

**(3-(4-chloronaphthalen-i-yl)phenyl)dimethylphosphine oxide**

A flask was flushed with nitrogen and charged with (4-chloronaphthalen-1-yl)boronic acid (10.0 g, 48.1 mmol), (3-bromophenyl)dimethylphosphine oxide (11.3 g, 48.4 mmol, 1.0 eq.), $Pd(PPh_3)_4$ (0.98 g, 0.85 mmol, 0.0175 eq.) and $K_2CO_3$ (10.0 g, 72.6 mmol, 1.5 eq.). A mixture of deaerated ethanol and water was added and the reaction mixture was heated to reflux under a nitrogen atmosphere overnight. After cooling to room temperature, the aqueous phase was separated and washed with toluene. The combined organic phases were filtered through a gel pad of Florisil and washed with toluene. After removal of most solvent, the product was precipitated with n-hexane. After filtration, the solid was recrystallized once in methyl tert-butylether and once in toluene/methanol. The solid was filtered and washed with ethyl acetate. The product resulted as a light brown solid, with HPLC purity 99.65%.

**Dimethyl(3-(4-(3-(2-phenylbenzo[h]quinazolin-4-yl)phenyl)naphthalen-1-yl)phenyl)phosphine oxide (E8)**

In a nitrogen flushed flask, (3-(4-chloronaphthalen-1-yl)phenyl)dimethylphosphine oxide (10.4 g, 32.75 mmol, 1.0 eq.) and 2-phenyl-4-(3-(4,4,5,5-tetramethyl-1,3,2-dioxaborolan-2-yl)phenyl)benzo[h]quinazoline (15.0 g, 32.75 mmol) were dissolved with chloro(crotyl)(2-dicyclohexylphosphino-2',6'-dimethoxybiphenyl)palladium(II) (CAS 1798781-99-3, 0.7 g, 1.16 mmol, 0.035 eq.) and $K_3PO_4$ (17.4 g, 81.9 mmol, 2.5 eq.) in a deaerated mixture of dioxane and water. The reaction mixture was stirred at reflux overnight. After cooling down to room temperature, precipitate was filtered off and washed with dioxane, water and ethanol. The solid was recrystallized in dichlormethane and heated with toluene. The product was filtered and washed with toluene and hexane. After sublimation as final purification step, the product was isolated as a fine solid, with HPLC purity 99.98%.

Supporting materials for device experiments

F1 is

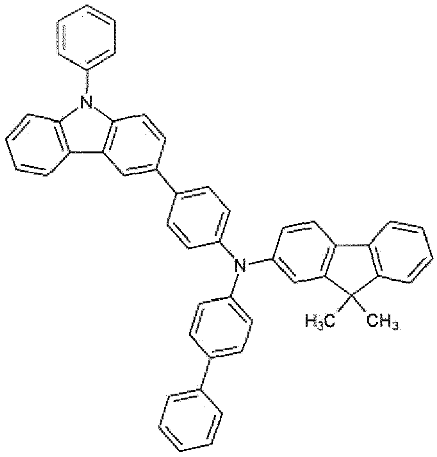

CAS 1242056-42-3

F2 is

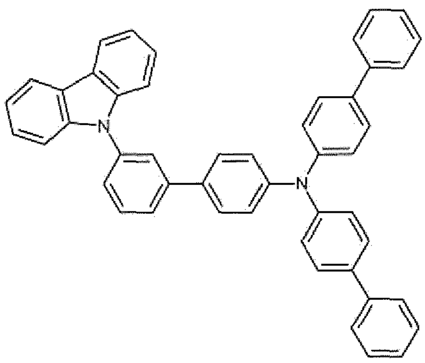

CAS 1464822-27-2

F3 is

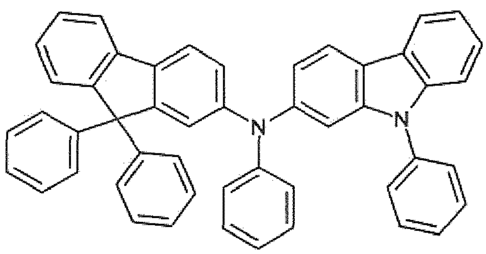

CAS 1607480-22-7

F4 is

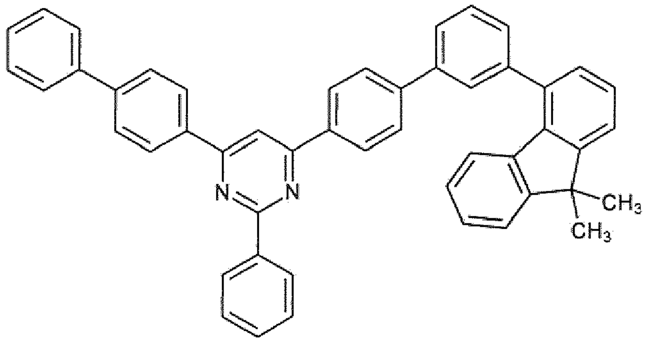

CAS 1955546-40-3

F5 is

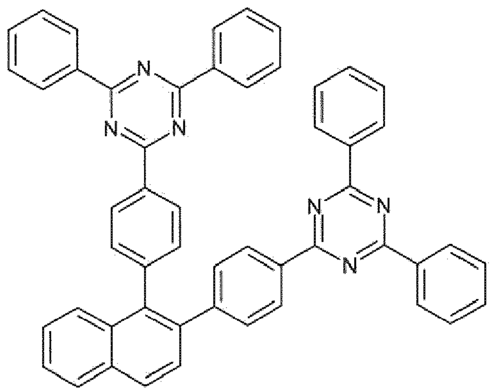

CAS 2244287-14-5

F6 is

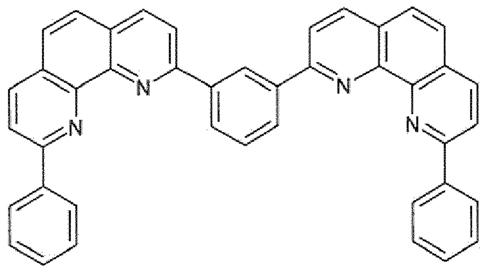

CAS 721969-94-4

F7 is

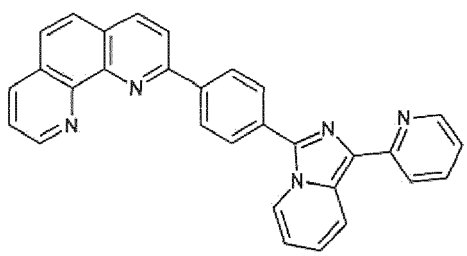

CAS 2646631-43-6

C1 is

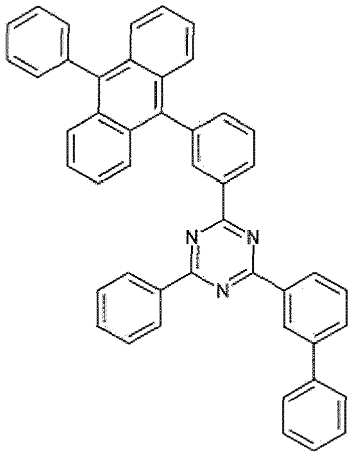

CAS 2437303-42-7

PD1 is

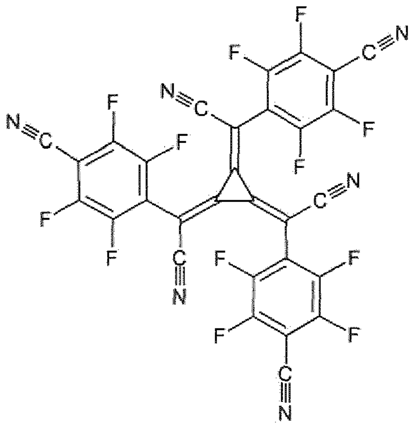

CAS 1224447-88-4

H09 is an emitter host and BD200 is a blue fluorescent emitter dopant, both commercially available from SFC, Korea.

<u>Standard procedures</u>

*Voltage stability*

OLEDs are driven by constant current circuits. Those circuits can supply a constant current over a given voltage range. The wider the voltage range, the wider the power losses of such devices. Hence, the change of driving voltage upon driving needs to be minimized.

The driving voltage of an OLED is temperature dependent. Therefore, voltage stability needs to be judged in thermal equilibrium. Thermal equilibrium is reached after one hour of driving.

Voltage stability is measured by taking the difference of the driving voltage after 50 hours and after 1 hour driving at a constant current density. Here, a current density of 30 mA/cm$^2$ is used. Measurements are done at room temperature.

$$dU\,[V] = U(50\,h,\,30\,mA/cm^2) - U(1\,h,\,30\,mA/cm^2)$$

Examples

1) Blue tandem OLED

Table 1a schematically describes the model device.

Table 1a:

| Layer | Material | Volume % | d (nm) |
|---|---|---|---|
| Cap layer | F1 | 100 | 75 |
| Cathode | Ag:Mg | 90:10 | 13 |
| EIL | Yb | 100 | 2 |
| ETL2 | F5: LiQ | 50:50 | 31 |
| HBL2 | F4 | 100 | 5 |
| EML2 | H09:BD200 | 99:1 | 19 |
| EBL2 | F2 | 100 | 5 |
| HTL2 | F3 | 100 | 45 |
| p-CGL | F3:PD1 | 91:9 | 10 |
| n-CGL | second electron transport compound :Yb | 98:2 | 7.5 |
| ETLi | first electron transport compound | 100 | 10 |
| HBLi | F4 | 100 | 5 |
| EML1 | H09:BD200 | 99:1 | 19 |
| EBLi | F2 | 100 | 5 |
| HTLi | F1 | 100 | 29 |
| HIL | F1:PD1 | 98:2 | 10 |
| Anode | Ag | 100 | 100 |

Results of the respective experiments are summarized in Table 1b.

Table 1b

| # | ETL | nCGL | CIE-y | j [mA/cm$^2$] | Voltage [V] / % | | CEff/CIE-y [cd/A] / % | |
|---|---|---|---|---|---|---|---|---|
| 1 | E4:C1 3:7 w/w | F6 | 0.062 | 6.31 | 6.45 | 100 | 325 | 100 |
| 2 | E1 | F6 | 0.055 | 6.44 | 6.26 | 97 | 331 | 102 |
| 3 | E5 | F6 | 0.063 | 6.25 | 6.23 | 97 | 327 | 101 |
| 4 | E7 | F6 | 0.055 | 6.62 | 6.44 | 100 | 333 | 102 |
| 5 | E8 | F6 | 0.053 | 6.44 | 6.26 | 97 | 337 | 104 |

In comparison with the device number 1, comprising a state-of-art ETL comprising the first electron transport compound according to invention diluted with compound C1, further devices in accordance with present claims, comprising the ETL consisting of undiluted first electron transport compound, exhibit lower operational voltage and/or higher current efficiency.

The features disclosed in the foregoing description and in the dependent claims may, both separately and in any combination thereof, be material for realizing the aspects of the disclosure made in the independent claims, in diverse forms thereof.

## Claims

**1.** Organic electroluminescent device comprising an anode, a cathode, a first electron transport layer, a first emission layer and a charge generation layer;
wherein

- the first emission layer, the first electron transport layer and the charge generation layer are arranged between the anode and the cathode;
- the charge generation layer comprises an n-type sub-layer;
- the first electron transport layer is in direct contact with the n-type sub-layer;
- the first electron transport layer is arranged between the first emission layer and the n-type sublayer;
- the first electron transport layer consists of a first electron transport compound comprising a functional group of formula (1)

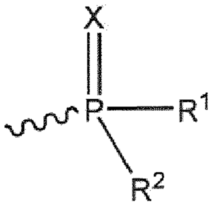
(1)

and a structural moiety selected from $C_6$ to $C_{60}$ aryl and $C_2$ to $C_{60}$ heteroaryl,
wherein

- X is selected from O, S or Se;
- $R^1$ and $R^2$ are independently selected from substituted or unsubstituted $C_1$ to $C_{16}$ alkyl, wherein the substituent of the substituted $C_1$ to $C_{16}$ alkyl is selected from $C_6$ to $C_{18}$ aryl or $C_2$ to $C_{12}$ heteroaryl;

the wavy line "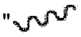 "represents a covalent bond of the P atom of the functional group (1) to the rest of the first electron transport compound;

- the n-type sub-layer comprises a second electron transport compound and a metal;
- wherein the second electron transport compound comprises at least two N-atoms; and
- the metal is selected from the group consisting of alkaline earth metals and rare earth metals.

**2.** Organic electroluminescent device according to claim 1, wherein the first electron transport compound has formula (2)

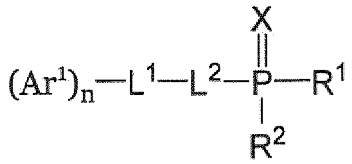
(2)

wherein

- X is selected from O, S or Se;
- $Ar^1$ is selected from the group consisting of unsubstituted or substituted $C_6$ to $C_{60}$ aryl and $C_2$ to $C_{60}$ heteroaryl,

  - wherein the substituent(s) of the substituted $C_2$ to $C_{60}$ heteroarylene, respectively the $C_6$ to $C_{60}$ arylene, are independently selected from D, $C_1$ to $C_{12}$ alkyl, $C_1$ to $C_{12}$ alkoxy, CN, OH, halogen, $C_6$ to $C_{32}$ aryl or $C_2$ to $C_{25}$ heteroaryl;

- n is 1 or 2;
- $L^1$ is selected from a single bond, $C_1$ to $C_4$ alkylene, or substituted or unsubstituted $C_6$ to $C_{36}$ arylene;

  - wherein the substituent(s) of the substituted $C_6$ to $C_{36}$ arylene, are independently selected from D, $C_1$ to $C_{12}$ alkyl, $C_1$ to $C_{12}$ alkoxy, CN, OH, halogen, $C_6$ to $C_{32}$ aryl or $C_2$ to $C_{25}$ heteroaryl;

- $L^2$ is selected from a single bond or $C_1$ to $C_6$ alkyl,
- $R^1$ and $R^2$ are independently selected from substituted or unsubstituted C. to $C_{16}$ alkyl, - wherein the substituent of the substituted $C_1$ to $C_{16}$ alkyl is selected from $C_6$ to $C_{18}$ aryl or $C_2$ to $C_{12}$ heteroaryl.

3. Organic electroluminescent device according to claim 1 or 2, wherein X is O.

4. Organic electroluminescent device according to claim 2 or 3, wherein $L^1$ is substituted or unsubstituted $C_6$ to $C_{36}$ arylene.

5. Organic electroluminescent device according to claim 4, wherein $L^2$ is a single bond.

6. Organic electroluminescent device according to any of the preceding claims, wherein $Ar^1$ is independently selected from the following structures

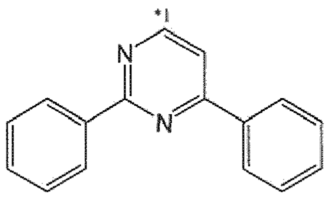 ; 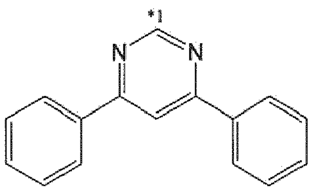 ; 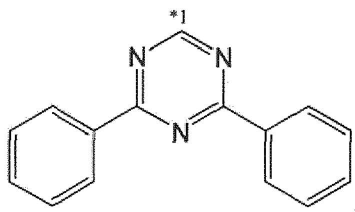 ;

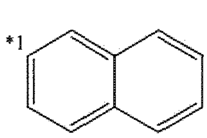 ; 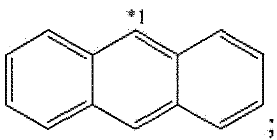 ; 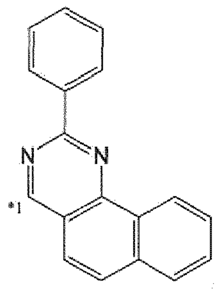 ; 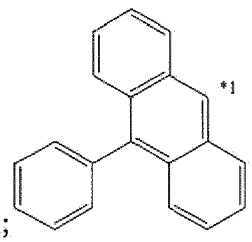

and

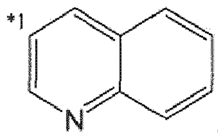 ,

wherein $Ar^1$ is bonded at *1 to $L^1$.

7. Organic electroluminescent device according to any of the preceding claims, wherein $R^1$ and $R^2$ are independently selected from $C_1$ to $C_8$ alkyl.

8. Organic electroluminescent device according to any of the preceding claims, wherein the first electron transport compound is selected from E1 to E8

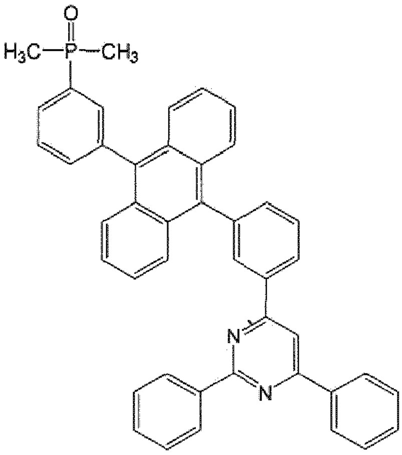
E1

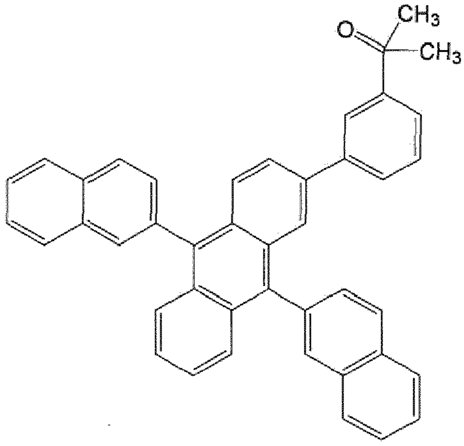
E2

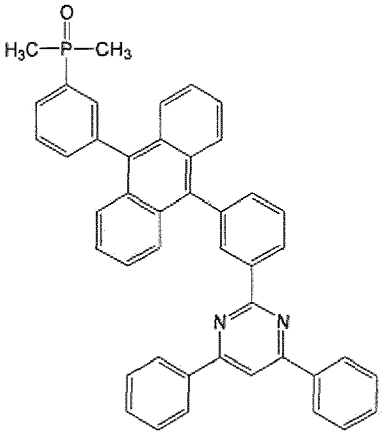
E3

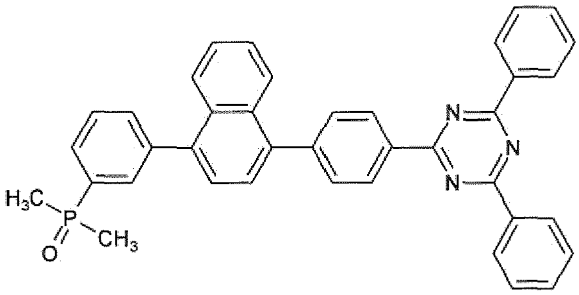
E4

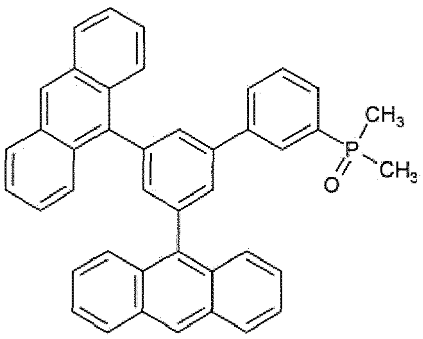
E5

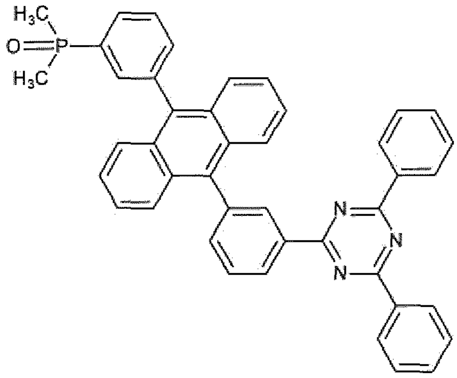
E6

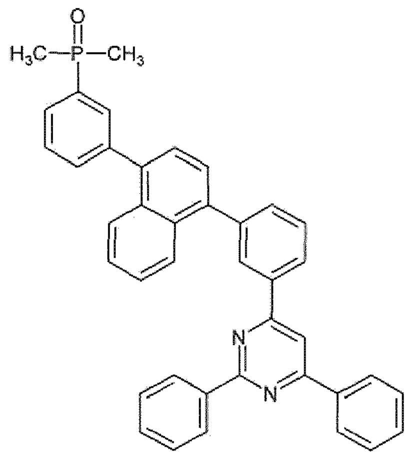

E7

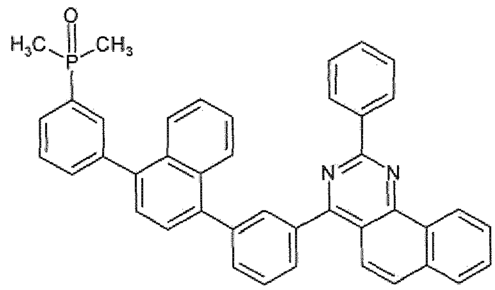

E8.

**9.** Organic electroluminescent device according to any of the preceding claims, wherein the second electron transport compound comprises a moiety consisting of 2 to 6 condensed aromatic rings.

**10.** Organic electroluminescent device according to claim 9, wherein the moiety consisting of 2 to 6 condensed aromatic rings is an arene moiety; preferably, the arene moiety is selected from the group consisting of naphthalene, anthracene, phenanthrene and pyrene.

**11.** Organic electroluminescent device according to any of the preceding claims, wherein the second electron transport compound comprises a heteroarene moiety selected from the group consisting of diazine, diazole, benzimidazole, imidazopyridine, phenanthroline, quinazoline. benzoquinazoline and quinoxaline, wherein the respective heteroarene moiety is unsubstituted or substituted with $C_6$ to $C_{18}$ aryl or $C_2$ to $C_{12}$ heteroaryl, wherein the $C_6$ to $C_{18}$ aryl or $C_2$ to $C_{12}$ heteroaryl may be substituted with one or more independently selected from $C_1$ to $C_4$ alkyl, respectively.

**12.** Organic electroluminescent device according to any of the preceding claims, further comprising a first hole blocking layer arranged between the first electron transport layer and the first emission layer.

**13.** Organic electroluminescent device according to any of the preceding claims, wherein the metal is a rare earth metal, preferably Yb.

**14.** Display device comprising the organic electroluminescent device according to any of the preceding claims.

**15.** Compound having formula selected from E7 and E8

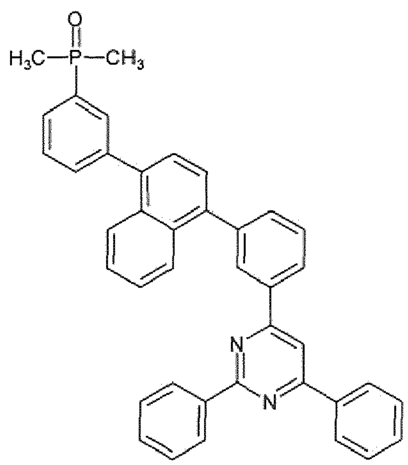

E7

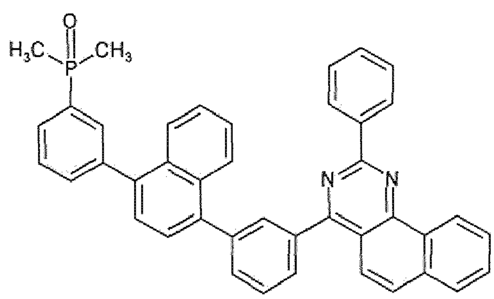

E8.

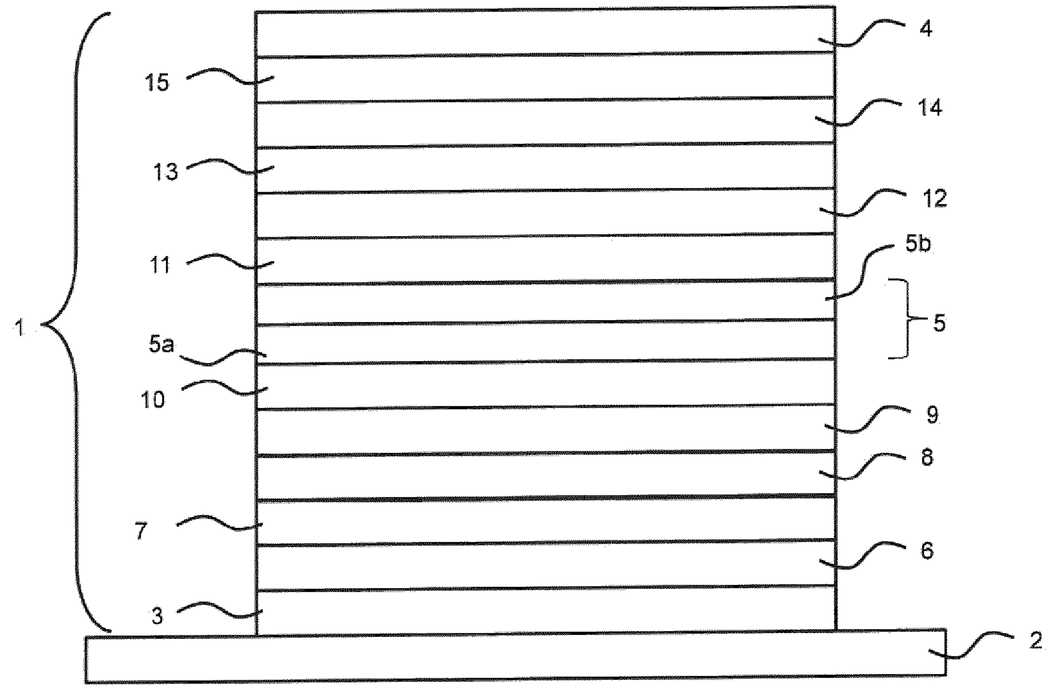
4
15
14
13
12
11
5b
1
5
5a
10
9
8
7
6
3
2

Fig. 1

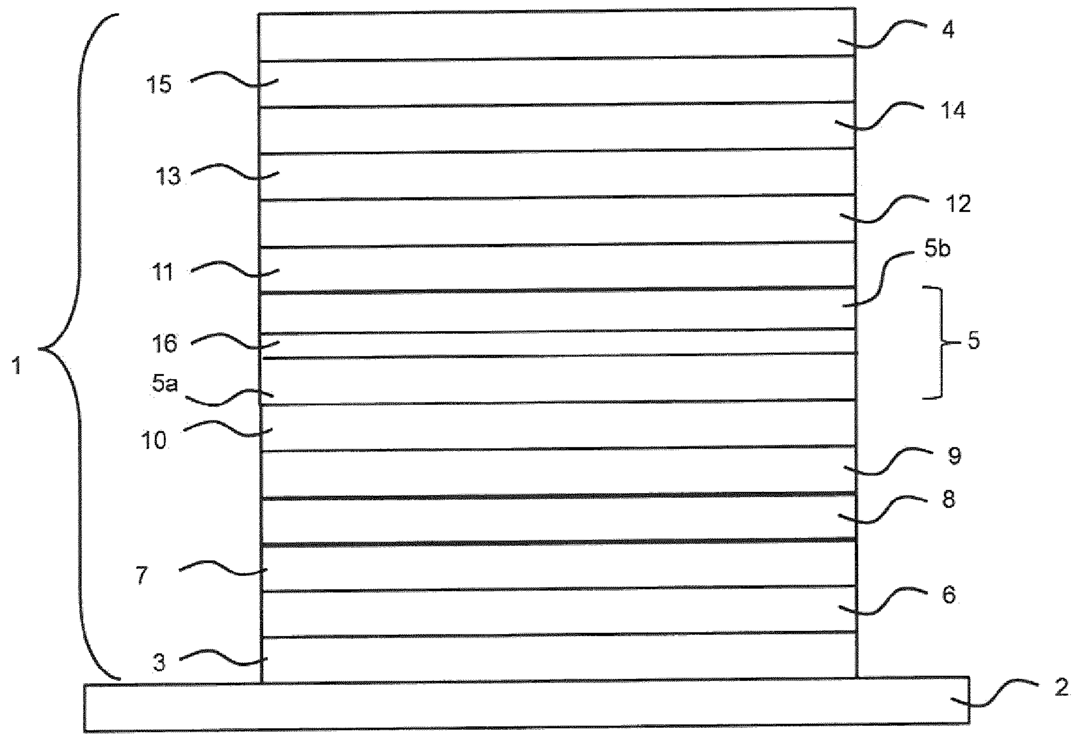
4
15
14
13
12
11
5b
1
16
5
5a
10
9
8
7
6
3
2

Fig. 2

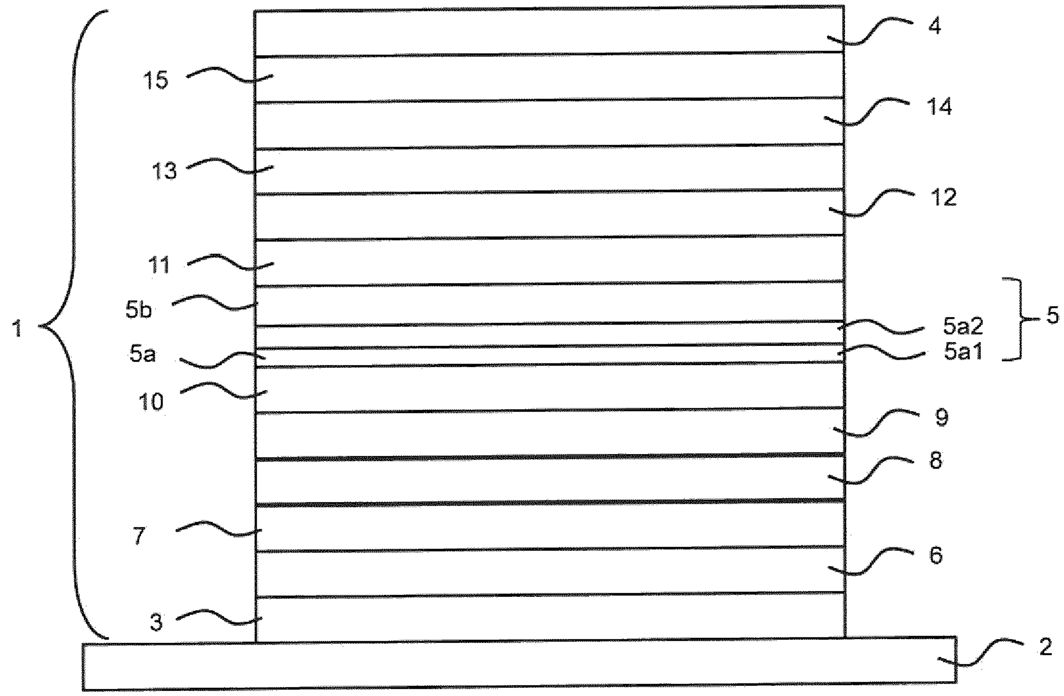


Fig. 3

Europäisches Patentamt
European Patent Office
Office européen des brevets

# EUROPEAN SEARCH REPORT

Application Number
EP 22 21 3855

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2021/250277 A1 (NOVALED GMBH [DE]) 16 December 2021 (2021-12-16) * the whole document * ----- | 1-14 | INV. H10K50/16 H10K85/60 H10K50/19 |
| X | US 2022/037595 A1 (SCHULZE BENJAMIN [DE] ET AL) 3 February 2022 (2022-02-03) * the whole document * ----- | 1-15 | |
| X | WO 2018/215355 A1 (NOVALED GMBH [DE]) 29 November 2018 (2018-11-29) * compound H57 * ----- | 15 | |

TECHNICAL FIELDS SEARCHED (IPC)

H10K

The present search report has been drawn up for all claims

2

| Place of search | Date of completion of the search | Examiner |
|---|---|---|
| Munich | 26 May 2023 | Wolfbauer, Georg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

Application Number
EP 22 21 3855

## CLAIMS INCURRING FEES

The present European patent application comprised at the time of filing claims for which payment was due.

- [ ] Only part of the claims have been paid within the prescribed time limit. The present European search report has been drawn up for those claims for which no payment was due and for those claims for which claims fees have been paid, namely claim(s):

- [ ] No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

- [x] All further search fees have been paid within the fixed time limit. The present European search report has been drawn up for all claims.

- [ ] As all searchable claims could be searched without effort justifying an additional fee, the Search Division did not invite payment of any additional fee.

- [ ] Only part of the further search fees have been paid within the fixed time limit. The present European search report has been drawn up for those parts of the European patent application which relate to the inventions in respect of which search fees have been paid, namely claims:

- [ ] None of the further search fees have been paid within the fixed time limit. The present European search report has been drawn up for those parts of the European patent application which relate to the invention first mentioned in the claims, namely claims:

- [ ] The present supplementary European search report has been drawn up for those parts of the European patent application which relate to the invention first mentioned in the claims (Rule 164 (1) EPC).

Europäisches Patentamt
European Patent Office
Office européen des brevets

# LACK OF UNITY OF INVENTION SHEET B

Application Number
EP 22 21 3855

The Search Division considers that the present European patent application does not comply with the requirements of unity of invention and relates to several inventions or groups of inventions, namely:

1. claims: 1-7, 9-14(completely); 8(partially)

OLEDs comprising phosphine compounds in the electron transporting layer.

---

2. claims: 15(completely); 8(partially)

Two very specific phosphine oxides.

---

## ANNEX TO THE EUROPEAN SEARCH REPORT ON EUROPEAN PATENT APPLICATION NO.

EP 22 21 3855

This annex lists the patent family members relating to the patent documents cited in the above-mentioned European search report. The members are as contained in the European Patent Office EDP file on
The European Patent Office is in no way liable for these particulars which are merely given for the purpose of information.

26-05-2023

| Patent document cited in search report | Publication date | Patent family member(s) | Publication date |
|---|---|---|---|
| WO 2021250277 A1 | 16-12-2021 | CN 115413374 A | 29-11-2022 |
| | | EP 3923364 A1 | 15-12-2021 |
| | | EP 4165693 A1 | 19-04-2023 |
| | | KR 20230024869 A | 21-02-2023 |
| | | TW 202212301 A | 01-04-2022 |
| | | WO 2021250277 A1 | 16-12-2021 |
| US 2022037595 A1 | 03-02-2022 | CN 113228325 A | 06-08-2021 |
| | | EP 3895227 A1 | 20-10-2021 |
| | | JP 2022511943 A | 01-02-2022 |
| | | KR 20210104100 A | 24-08-2021 |
| | | US 2022037595 A1 | 03-02-2022 |
| | | WO 2020120793 A1 | 18-06-2020 |
| WO 2018215355 A1 | 29-11-2018 | CN 110892545 A | 17-03-2020 |
| | | EP 3407401 A1 | 28-11-2018 |
| | | KR 20200008622 A | 28-01-2020 |
| | | US 2020095269 A1 | 26-03-2020 |
| | | WO 2018215355 A1 | 29-11-2018 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 1837926 A1
- WO 07107306 A1
- WO 07107356 A1
- EP 2722908 A1
- EP 1970371 A1
- WO 2013079217 A1


### Non-patent literature cited in the description


- **YASUHIKO SHIROTA ; HIROSHI KAGEYAMA.** *Chem. Rev.,* 2007, vol. 107, 953-1010